# EUROPEAN PATENT APPLICATION

(11) **EP 1 739 064 A1**
(43) Date of publication of application: **03.01.2007**
(21) Application number: 06253318.7
(22) Date of filing: 26.06.2006
(51) Int. Cl.: C04B 35/493, H01L 41/187, H01L 41/083

(54) **Piezoelectric/electrostrictive porcelain composition, piezoelectric/electrostrictive body, and piezoelectric/electrostrictive film type device**

(30) Priority: 27.06.2005 JP 2005186282
(71) Applicant: NGK INSULATORS, LTD., Nagoya-City, Aichi Pref. 467-8530 (JP)
(72) Inventor: Kitagawa, Mutsumi c/o NGK Insulators Ltd., Nagoya City, Aichi-ken 467-8530 (JP); Kashiwaya, Toshikatsu c/o NGK Insulators Ltd., Nagoya City, Aichi-ken 467-8530 (JP)
(74) Representative: Paget, Hugh Charles Edward

(57) **Abstract**

There is disclosed a piezoelectric/electrostrictive porcelain composition capable of constituting a bulk-like or film-like piezoelectric/electrostrictive body which is dense and which has a large strain or displacement. A piezoelectric/electrostrictive porcelain composition contains: a PbMg_{1/3}Nb_{2/3}O₃-PbTiO₃-PbZrO₃ ternary solid solution system composition as a main component; and 0.05 to 3.0 mass% of Ni in terms of NiO, or contains: a Pb(Mg, Ni)_{1/3}Nb_{2/3}O₃-PbTiO₃-PbZrO₃ ternary solid solution system composition as a main component; and at least one selected from the group consisting of Mg₂SiO₄, Ni₂SiO₄ and (Mg, Ni)₂SiO₄, and a total content ratio of Mg₂SiO₄, Ni₂SiO₄ and (Mg, Ni)₂SiO₄ is 0.2 mol% or less.

## Description

### BACKGROUND OF THE INVENTION

### 1. Field of the Invention

The present invention relates to a piezoelectric/electrostrictive porcelain composition, a piezoelectric/electrostrictive body and a piezoelectric/electrostrictive film type device, more particularly to a piezoelectric/electrostrictive porcelain composition capable of constituting a bulk-like or film-like piezoelectric/electrostrictive body which is dense and which has a large strain or displacement, a dense and highly-strong bulk-like piezoelectric/electrostrictive body having a large displacement and having less micro cracks generated during long-term use, and a piezoelectric/electrostrictive film type device including a dense and highly-strong film-like piezoelectric/electrostrictive body having a large displacement and having less micro cracks generated during long-term use.

### 2. Description of the Related Art

Heretofore, as an element in which a micro displacement of the order of sub-microns can be controlled, a piezoelectric/electrostrictive film type device has been known. Especially a piezoelectric/electrostrictive film type device is suitable for the control of the micro displacement, in which there are laminated, on a substrate made of a ceramic, a film-like piezoelectric/electrostrictive body (piezoelectric/electrostrictive portion) formed of a piezoelectric/electrostrictive porcelain composition and a film-like electrode. A voltage is to be applied to the electrode. In addition, the piezoelectric/electrostrictive film type device has excellent characteristics such as a high electromechanical conversion efficiency, a high-speed response, a high durability and a saved power consumption. Such piezoelectric/electrostrictive film type device is used in various applications such as a piezoelectric pressure sensor, a probe moving mechanism of a scanning tunnel microscope, a rectilinear guiding mechanism in an ultra-precise working device, a hydraulic controlling servo motor, a head of a VTR device, pixels constituting a flat panel type image display device and a head of an ink jet printer.

Moreover, a piezoelectric/electrostrictive porcelain composition constituting the piezoelectric/electrostrictive body is also variously investigated. There are disclosed, for example, a Pb(Mg_{1/3}Nb_{2/3})O₃-PbTiO₃-PbZrO₃ ternary solid solution system composition and a piezoelectric/electrostrictive porcelain composition constituting by replacing a part of Pb of the ternary solid solution system composition with Sr, La or the like (see, e.g., Patent Documents 1 and 2). It is expected that the piezoelectric/electrostrictive element having an excellent piezoelectric/electrostrictive characteristic (e.g., piezoelectric d constant) is obtained by the piezoelectric/electrostrictive body itself as the most important portion that determines the piezoelectric/electrostrictive characteristic of the piezoelectric/electrostrictive element.

On the other hand, it is disclosed that when the piezoelectric/electrostrictive body is formed using the piezoelectric/electrostrictive porcelain containing, as a main component, a predetermined PMN-PZ-PT ternary solid solution system composition including Ni, an oxide thereof or the like, it is possible to manufacture a piezoelectric/electrostrictive element having the excellent piezoelectric/electrostrictive characteristic. The piezoelectric/electrostrictive element also has a high linearity of a flexure displacement with respect to a high electric-field region (see, e.g., Patent Documents 3 and 4).

However, it cannot be said that even the piezoelectric/electrostrictive elements disclosed in Patent Documents 3 and 4 necessarily satisfy characteristics required for an ultra-precise device and the like which have rapidly progressed and developed in recent years. To be more specific, in a case where the piezoelectric/electrostrictive element is attached to the device or the like in which the control of the micro displacement is further required, the element needs to be dense and have an excellent piezoelectric/electrostrictive characteristic and a large displacement. However, under the present circumstances, there have not been found yet the piezoelectric/electrostrictive body and element which satisfy such high requirements and the piezoelectric/electrostrictive porcelain composition constituting them.
[Patent Document 1] Japanese Patent Publication No. 44-17103
[Patent Document 2] Japanese Patent Publication No. 45-8145
[Patent Document 3] Japanese Patent Application Laid-Open No. 2002-217464
[Patent Document 4] Japanese Patent Application Laid-Open No. 2002-217465

### SUMMARY OF THE INVENTION

The present invention has been developed in view of such problems of the conventional technology, and an object thereof is to provide a piezoelectric/electrostrictive porcelain composition capable of constituting a dense bulk-like or film-like piezoelectric/electrostrictive body having a large distortion or displacement, a dense and highly-strong bulk-like piezoelectric/electrostrictive body having a large distortion and having less micro cracks generated during long-term use, and a piezoelectric/electrostrictive film type device including a dense and highly-strong film-like piezoelectric/electrostrictive body having a large displacement and having less micro cracks generated during long-term use.

As a result of intensive investigation for achieving the above object by the present inventors, it has been found that the above object can be achieved, when a slight amount of component including forsterite (Mg₂SiO₄) is further contained in a piezoelectric/electrostrictive porcelain composition component containing NiO or containing a predetermined ternary solid solution system composition including an Ni element in a structure of the composition, and the present invention has been developed.

That is, according to the present invention, there are provided the following piezoelectric/electrostrictive porcelain composition, piezoelectric/electrostrictive body and piezoelectric/electrostrictive film type device.

[1] A piezoelectric/electrostrictive porcelain composition containing: a PbMg_{1/3}Nb_{2/3}O₃-PbTiO₃-PbZrO₃ ternary solid solution system composition as a main component; and 0.05 to 3.0 mass% of Ni in terms of NiO, or containing: a Pb(Mg, Ni)_{1/3}Nb_{2/3}O₃-PbTiO₃-PbZrO₃ ternary solid solution system composition as a main component; and at least one selected from the group consisting of Mg₂SiO₄, Ni₂SiO₄ and (Mg, Ni)₂SiO₄, a total content ratio of Mg₂SiO₄, Ni₂SiO₄ and (Mg, Ni)₂SiO₄ being 0.2 mol% or less.
[2] The piezoelectric/electrostrictive porcelain composition according to the above [1], wherein the PbMg_{1/3}Nb_{2/3}O₃-PbTiO₃-PbZrO₃ ternary solid solution system composition is represented by the following formula (1):

   Pbₓ (Mg_{y/3}Nb_{2/3})ₐTi_{b}Zr_{c}O₃ (1),

   wherein 0.95 ≤ x ≤ 1.05, 0.8 ≤ y ≤ 1.0, and a, b and c are decimals in a region surrounded with (a, b, c) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including a, b and c as three coordinate axes (with the proviso that a+b+c = 1.000).
[3] The piezoelectric/electrostrictive porcelain composition according to the above [1] or [2], wherein the Pb (Mg, Ni)_{1/3}Nb_{2/3}O₃-PbTiO₃-PbZrO₃ ternary solid solution system composition is represented by the following formula (2) :

   Pbₓ{(Mg_{1-y}Ni_{y}) _{(1/3)}×ₐNb_{2/3}}_{b}Ti_{c}Zr_{d}O₃ (2),

   wherein 0.95 ≤ x ≤ 1.05, 0.05 ≤ y ≤ 1.00, 0.90 ≤ a ≤ 1.10, and b, c and d are decimals in a region surrounded with (b, c, d) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including b, c and d as coordinate axes (with the proviso that (b+c+d) = 1.000).
[4] A piezoelectric/electrostrictive body containing: a PbMg_{1/3}Nb_{2/3}O₃-PbTiO₃-PbZrO₃ ternary solid solution system composition as a main component; and 0.05 to 3.0 mass% of Ni in terms of NiO, or containing: a Pb(Mg, Ni)_{1/3}Nb_{2/3}O₃-PbTiO₃-PbZrO₃ ternary solid solution system composition as a main component; and at least one selected from the group consisting of Mg₂SiO₄, Ni₂SiO₄ and (Mg, Ni)₂SiO₄, a total content ratio of Mg₂SiO₄, Ni₂SiO₄ and (Mg, Ni)₂SiO₄ being 0.2 mol% or less.
[5] The piezoelectric/electrostrictive body according to the above [4], wherein the PbMg_{1/3}Nb_{2/3}O₃-PbTiO₃-PbZrO₃ ternary solid solution system composition is represented by the following formula (1):

   Pbₓ(Mg_{y/3}Nb_{2/3})ₐTi_{b}Zr_{c}O₃ (1),

   wherein 0.95 ≤ x ≤ 1.05, 0.8 ≤ y ≤ 1.0, and a, b and c are decimals in a region surrounded with (a, b, c) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including a, b and c as three coordinate axes (with the proviso that a+b+c = 1.000).
[6] The piezoelectric/electrostrictive body according to the above [4] or [5], wherein the Pb(Mg, Ni)_{1/3}Nb_{2/3}O₃-PbTiO₃-PbZrO₃ ternary solid solution system composition is represented by the following formula (2):

   Pbₓ{ (Mg_{1-y}Ni_{y}) _{(1/3)}×ₐNb_{2/3}}_{b}Ti_{c}Zr_{d}O₃ (2),

   wherein 0.95 ≤ x ≤ 1.05, 0.05 ≤ y ≤ 1.00, 0.90 ≤ a ≤ 1.10, and b, c and d are decimals in a region surrounded with (b, c, d) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including b, c and d as coordinate axes (with the proviso that (b+c+d) = 1.000).
[7] A piezoelectric/electrostrictive film type device (hereinafter referred to also as "the first piezoelectric/electrostrictive film type device") comprising: a substrate made of a ceramic; the piezoelectric/electrostrictive body formed into a film according to any one of the above [4] to [6]; and a film-like electrode electrically connected to the piezoelectric/electrostrictive body, the piezoelectric/electrostrictive body being solidly attached to the substrate directly or via the electrode.
[8] The piezoelectric/electrostrictive film type device according to the above [7], further comprising: a plurality of piezoelectric/electrostrictive bodies; and a plurality of electrodes, the plurality of piezoelectric/electrostrictive bodies being alternately sandwiched between and laminated on the plurality of electrodes.
[9] A piezoelectric/electrostrictive film type device (hereinafter referred to also as "the second piezoelectric/electrostrictive film type device") comprising: a substrate made of a ceramic; a plurality of piezoelectric/electrostrictive bodies formed into films; and a plurality of film-like electrodes electrically connected to the piezoelectric/electrostrictive bodies, the piezoelectric/electrostrictive bodies and the electrodes being alternately laminated on the substrate, a lowermost piezoelectric/electrostrictive body positioned in a lowermost layer of the piezoelectric/electrostrictive bodies being solidly attached to the substrate directly or via a lowermost electrode positioned in a lowermost layer of the electrodes, wherein at least one of the piezoelectric/electrostrictive bodies is constituted of the following piezoelectric/electrostrictive body (1), and at least one of the other piezoelectric/electrostrictive bodies is constituted of the following piezoelectric/electrostrictive body (2):
   (1) a piezoelectric/electrostrictive body containing: a PbMg_{1/3}Nb_{2/3}O₃-PbTiO₃-PbZrO₃ ternary solid solution system composition as a main component; 0.05 to 3.0 mass% of Ni in terms of NiO; and at least one selected from the group consisting of Mg₂SiO₄, Ni₂SiO₄ and (Mg, Ni)₂SiO₄, a total content ratio of Mg₂SiO₄, Ni₂SiO₄ and (Mg, Ni)₂SiO₄ being 0.2 mol% or less; and
   (2) a piezoelectric/electrostrictive body containing: a Pb(Mg, Ni)_{1/3}Nb_{2/3}O₃-PbTiO₃-PbZrO₃ ternary solid solution system composition as a main component; and at least one selected from the group consisting of Mg₂SiO₄, Ni₂SiO₄ and (Mg, Ni)₂SiO₄, a total content ratio of Mg₂SiO₄, Ni₂SiO₄ and (Mg, Ni)₂SiO₄ being 0.2 mol% or less.
[10] The piezoelectric/electrostrictive film type device according to the above [9], wherein the PbMg_{1/3}Nb_{2/3}O₃-PbTiO₃-PbZrO₃ ternary solid solution system composition is represented by the following formula (1):

   Pbₓ(Mg_{y/3}Nb_{2/3})ₐTi_{b}Zr_{c}O₃ (1),

   wherein 0.95 ≤ x ≤ 1.05, 0.8 ≤ y ≤ 1.0, and a, b and c are decimals in a region surrounded with (a, b, c) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including a, b and c as three coordinate axes (with the proviso that a+b+c = 1.000).
[11] The piezoelectric/electrostrictive film type device according to the above [9] or [10], wherein the Pb (Mg, Ni)_{1/3}Nb_{2/3}O₃-PbTiO₃-PbZrO₃ ternary solid solution system composition is represented by the following formula (2):

   Pbₓ{(Mg_{1-y}Ni_{y})_{(1/3)}×ₐNb_{2/3}}_{b}Ti_{c}Zr_{d}O₃ (2),

   wherein 0.95 ≤ x ≤ 1.05, 0.05 ≤ y ≤ 1.00, 0.90 ≤ a ≤ 1.10, and b, c and d are decimals in a region surrounded with (b, c, d) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including b, c and d as coordinate axes (with the proviso that (b+c+d) = 1.000).
[12] The piezoelectric/electrostrictive film type device according to any one of the above [9] to [11], wherein a content of Ni of the lowermost piezoelectric/electrostrictive body in terms of NiO is smaller than that of Ni of the piezoelectric/electrostrictive body other than the lowermost piezoelectric/electrostrictive body in terms of NiO.

The piezoelectric/electrostrictive porcelain composition of the present invention produces an effect that it is possible to constitute a bulk-like or film-like piezoelectric/electrostrictive body which is dense and which has a large strain or displacement.

The piezoelectric/electrostrictive body of the present invention produces an effect that the article is dense, has a large strain, has less micro cracks generated during long-term use, and has a high strength.

The first and second piezoelectric/electrostrictive film type devices of the present invention produce an effect that each element is dense, has a large displacement, has less micro cracks generated during long-term use, and has a high strength.

### BRIEF DESCRIPTION OF THE DRAWINGS

FIG. 1 is a sectional view schematically showing a first embodiment of a piezoelectric/electrostrictive film type device of the present invention;
FIG. 2 is a sectional view schematically showing another embodiment of the piezoelectric/electrostrictive film type device of the present invention;
FIG. 3 is a sectional view schematically showing still another embodiment of the piezoelectric/electrostrictive film type device of the present invention;
FIG. 4 is a sectional view schematically showing a further embodiment of the piezoelectric/electrostrictive film type device of the present invention;
FIG. 5(a) is a top plan view schematically showing a further embodiment of the piezoelectric/electrostrictive film type device of the present invention;
FIG. 5(b) is a sectional view schematically showing a still further embodiment of the piezoelectric/electrostrictive film type device of the present invention;
FIG. 6 is a sectional view showing one typical example of the embodiment shown in FIG. 3;
FIG. 7 is a sectional view showing another typical example of the embodiment shown in FIG. 3;
FIG. 8 is a sectional view showing still another typical example of the embodiment shown in FIG. 3;
FIG. 9 is a sectional view showing a further typical example of the embodiment shown in FIG. 3;
FIG. 10 is a sectional view showing a further typical example of the embodiment shown in FIG. 3;
FIG. 11 is a sectional view showing a still further example of the embodiment shown in FIG. 3;
FIG. 12(a) is a sectional view of the embodiment cut along the line X-X' shown in FIG. 6; and
FIG. 12(b) is a top plan view of the embodiment shown in FIG. 6.

### DESCRIPTION OF THE PREFERRED EMBODIMENT

Preferable embodiments of the present invention will be described hereinafter, but it should be understood that the present invention is not limited to the following embodiments and that the scope of the present invention includes appropriate modification, improvement and the like applied to the following embodiments based on usual knowledge of a person skilled in the art without departing from the scope of the present invention. It is to be noted that when "the piezoelectric/electrostrictive element of the present invention (present embodiment)" is simply referred to in the present specification, either of first and second piezoelectric/electrostrictive film type devices is indicated.

In an embodiment of the present invention, a piezoelectric/electrostrictive porcelain composition contains: a PbMg_{1/3}Nb_{2/3}O₃-PbTiO₃-PbZrO₃ ternary solid solution system composition as a main component; and 0.05 to 3.0 mass% of Ni in terms of NiO, or contains: Pb(Mg, Ni)_{1/3}Nb_{2/3}O₃-PbTiO₃-PbZrO₃ ternary solid solution system composition as a main component; and at least one selected from the group consisting of Mg₂SiO₄ (forsterite), Ni₂SiO₄ and (Mg, Ni)₂SiO₄. A total content ratio of Mg₂SiO₄, Ni₂SiO₄ and (Mg, Ni)₂SiO₄ is 0.2 mol% or less. The embodiment will be described hereinafter in detail. It is to be noted that "forsterite or the like" mentioned in the present specification means a compound of all of Mg₂SiO₄ (forsterite), Ni₂SiO₄ and (Mg, Ni)₂SiO₄.

The piezoelectric/electrostrictive porcelain composition of the present embodiment contains the PbMg_{1/3}Nb_{2/3}O₃-PbTiO₃-PbZrO₃ ternary solid solution system composition as the main component and 0.05 to 3.0 mass% of Ni in terms of NiO, or contains the Pb(Mg, Ni)_{1/3}Nb_{2/3}O₃-PbTiO₃-PbZrO₃ ternary solid solution system composition as the main component. That is, the piezoelectric/electrostrictive porcelain composition of the present embodiment contains a predetermined ratio of Ni in terms of NiO, or contains, as the main component, the Pb(Mg, Ni)_{1/3}Nb_{2/3}O₃-PbTiO₃-PbZrO₃ ternary solid solution system composition in which a part of Mg is replaced with Ni. Therefore, when the piezoelectric/electrostrictive porcelain composition of the present embodiment is fired or treated otherwise, it is possible to obtain a piezoelectric/electrostrictive body in which a pyrochlore phase is inhibited from being formed and in which a ratio occupied by a perovskite phase contributing to an electric field induced strain is large and which is dense and which has a remarkably high piezoelectric/electrostrictive characteristic.

Moreover, the piezoelectric/electrostrictive porcelain composition of the present embodiment further contains at least one selected from the group consisting of Mg₂SiO₄, Ni₂SiO₄ and (Mg, Ni)₂SiO₄. Since the piezoelectric/electrostrictive porcelain composition of the present embodiment contains the forsterite and the like in this manner, it is possible to manufacture a bulk-like or film-like piezoelectric/electrostrictive body which is dense and which has a large strain or displacement.

In general, the forsterite has a characteristic that a coefficient of thermal expansion is comparatively high (9.8×10⁻⁶/°C, 40 to 400°C). Here, there will be considered a process of firing the piezoelectric/electrostrictive porcelain composition to obtain a sintered article, and polarizing the resultant sintered article to thereby obtain the piezoelectric/electrostrictive body. In a cooling process after the firing, when a temperature higher than the Curie point drops below the Curie point, spontaneous polarization is generated in the sintered article. When a crystal structure of the sintered article changes from a cubic structure to a tetragonal structure, an inner stress (inner stress attributable to a phase change) is generated. Here, when the specific forsterite is finely and uniformly dispersed in the sintered article, the forsterite contracts more largely than the sintered article. Therefore, the inner stress (inner stress attributable to a thermal expansion difference) is generated. Since the inner stress attributable to this thermal expansion difference is generated, the inner stress generated during polarization generates the spontaneous polarization so as to reduce the inner stress attributable to the thermal expansion difference. Therefore, in a case where there is used a piezoelectric/electrostrictive porcelain composition containing a specific amount of forsterite, the inner stress of the sintered article obtained after the firing is reduced as compared with a case where there is used a piezoelectric/electrostrictive porcelain composition which does not contain any forsterite. In consequence, it is speculated that it is possible to obtain a piezoelectric/electrostrictive body having a high strength and a large distortion or displacement. In the article, polarization can largely move owing to the small inner stress during the polarization performed by applying an electric field to the piezoelectric/electrostrictive body. The article is dense and has a large electric field induced strain. When the article is driven with the large strain or displacement for a long time, less micro cracks are generated owing to the small inner stress.

In the piezoelectric/electrostrictive porcelain composition of the present embodiment, the total content ratio (content ratio of the forsterite, etc.) of Mg₂SiO₄, Ni₂SiO₄ and (Mg, Ni)₂SiO₄ is 0.2 mol% or less, preferably 0.03 to 0.18 mol%, further preferably 0.05 to 0.15 mol%. When the content ratio of the forsterite and the like exceeds 0.2 mol%, an effect derived by making forsterite incorporated therein is reduced since grains of the forsterite and the like become coarse, and cannot be finely or uniformly dispersed in the sintered article. Additionally, it is not favorable since the strain or the displacement of the resultant piezoelectric/electrostrictive body is reduced due to the increase in a volume ratio of a forsterite phase showing no piezoelectric/electrostrictive property.

Moreover, in a case where the piezoelectric/electrostrictive porcelain composition of the present embodiment contains the PbMg_{1/3}Nb_{2/3}O₃-PbTiO₃-PbZrO₃ ternary solid solution system composition, the content ratio of Ni is 0.05 to 3.0 mass%, preferably 0.07 to 2.5 mass%, further preferably 0.10 to 2 mass% in terms of NiO. When the content ratio of Ni is within the above numeric value range in terms of NiO, it is possible to manufacture a dense piezoelectric/electrostrictive body having a remarkably high piezoelectric/electrostrictive characteristic. In the manufactured piezoelectric/ electrostrictive body, the pyrochlore phase can be inhibited from being generated, and the ratio occupied by the perovskite phase contributing to the electrically induced strain is large.

It is to be noted that when "the PbMg_{1/3}Nb_{2/3}O₃-PbTiO₃-PbZrO₃ ternary solid solution system composition as the main component" is referred to in the present specification, "the main component" indicates that the PbMg_{1/3}Nb_{2/3}O₃-PbTiO₃-PbZrO₃ ternary solid solution system composition has a content ratio of 99.5 mass% or more, preferably 99.8 mass% or more with respect to the whole piezoelectric/ electrostrictive porcelain composition excluding Ni, the forsterite and the like.

Moreover, when "the Pb(Mg, Ni)_{1/3}Nb_{2/3}O₃-PbTiO₃-PbZrO₃ ternary solid solution system composition as the main component" is referred to in the present specification, "the main component" indicates that the Pb(Mg, Ni)_{1/3}Nb_{2/3}O₃-PbTiO₃-PbZrO₃ ternary solid solution system composition has a content ratio of 99.5 mass% or more, preferably 99.8 mass% or more with respect to the whole piezoelectric/electrostrictive porcelain composition excluding the forsterite and the like.

In the piezoelectric/electrostrictive porcelain composition of the present embodiment, the PbMg_{1/3}Nb_{2/3}O₃-PbZrO₃-PbTiO₃, ternary solid solution system composition is preferably represented by the following composition formula (1) :

Pbₓ(Mg_{y/3}Nb_{2/3})ₐTi_{b}Zr_{c}O₃ (1),

because it is possible to form the piezoelectric/electrostrictive body having higher piezoelectric/electrostrictive characteristic.
In the formula (1), 0.95 ≤ x ≤ 1.05, 0.8 ≤ y ≤ 1.0, and a, b and c are decimals in a region surrounded with (a, b, c) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including a, b and c as three coordinate axes (with the proviso that a+b+c = 1.000).

Furthermore, in the piezoelectric/electrostrictive porcelain composition of the present embodiment, the Pb(Mg, Ni)_{1/3}Nb_{2/3}O₃-PbTiO₃-PbZrO₃ ternary solid solution system composition is represented by the following formula (2):

Pbₓ{(Mg_{1-y}Ni_{y})_{(1/3)}×ₐNb_{2/3}}_{b}Ti_{c}Zr_{d}O₃ (2),

because it is possible to form the piezoelectric/electrostrictive body having higher piezoelectric/electrostrictive characteristic.
In the formula (2), 0.95 ≤ x ≤ 1.05, 0.05 ≤ y ≤ 1.00, 0.90 ≤ a ≤ 1.10, and b, c and d are decimals in a region surrounded with (b, c, d) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including b, c and d as coordinate axes (with the proviso that (b+c+d) = 1.000).

In the piezoelectric/electrostrictive porcelain composition of the present embodiment, it is preferable that Pb in the piezoelectric/electrostrictive porcelain composition is replaced with at least one element selected from the group consisting of Sr, Ba, La and Bi, because it is possible to further improve the piezoelectric/electrostrictive characteristic of the resultant piezoelectric/electrostrictive body.

However, when Pb is replaced with at least one element selected from the group consisting of Sr, Ba, La and Bi at a high replacement ratio, the piezoelectric/electrostrictive characteristic of the resultant piezoelectric/electrostrictive body is sometimes deteriorated, or a fluctuation of the piezoelectric/electrostrictive characteristic due to a temperature change sometimes increases. Therefore, to replace a part of Pb with Sr and/or Ba, preferably 3 to 10 mol%, further preferably 5 to 8 mol% of Pb is replaced with Sr and/or Ba. To replace a part of Pb with La and/or Bi, preferably 0.2 to 1.0 mol%, further preferably 0.4 to 0.9 mol% of Pb is replaced with La and/or Bi.

In the piezoelectric/electrostrictive porcelain composition of the present embodiment, it is preferable that Ti in the piezoelectric/electrostrictive porcelain composition is replaced with at least one element selected from the group consisting of Nb, Ta, W and Mo, because it is possible to further improve the piezoelectric/electrostrictive characteristic of the resultant piezoelectric/electrostrictive body. It is to be noted that preferably 3 to 10 mol%, further preferably 5 to 8 mol% of Ti is replaced with at least one element selected from the group consisting of Nb, Ta, W and Mo.

It is preferable that the piezoelectric/electrostrictive porcelain composition of the present embodiment further contains MnO₂ and/or CeO₂, because it is possible to further improve the piezoelectric/electrostrictive characteristic of the resultant piezoelectric/electrostrictive body. It is to be noted that a content ratio of MnO₂ and/or CeO₂ is preferably 0.05 to 5 mass%, further preferably 0.1 to 2 mass%.

It is essentially preferable that the piezoelectric/electrostrictive porcelain composition of the present embodiment contains the PbMg_{1/3}Nb_{2/3}O₃-PbTiO₃-PbZrO₃ ternary solid solution system composition and 0.05 to 3.0 mass% of Ni in terms of NiO, or contains the Pb(Mg, Ni)_{1/3}Nb_{2/3}O₃-PbTiO₃-PbZrO₃ ternary solid solution system composition and the forsterite and the like having a content ratio of 0.2 mol% or less.

Next, there will be described one embodiment of the piezoelectric/electrostrictive body of the present invention. The piezoelectric/electrostrictive body of the present embodiment contains: a PbMg_{1/3}Nb_{2/3}O₃-PbTiO₃-PbZrO₃ ternary solid solution system composition as a main component; and 0.05 to 3.0 mass% of Ni in terms of NiO, or contains: a Pb(Mg, Ni)_{1/3}Nb_{2/3}O₃-PbTiO₃-PbZrO₃ ternary solid solution system composition as a main component; and at least one selected from the group consisting of Mg₂SiO₄, Ni₂SiO₄ and (Mg, Ni)₂SiO₄. A total content ratio of Mg₂SiO₄, Ni₂SiO₄, and (Mg, Ni)₂SiO₄ is 0.2 mol% or less. The article is a so-called bulk article. The embodiment will be described hereinafter in detail.

The piezoelectric/electrostrictive body of the present embodiment contains the PbMg_{1/3}Nb_{2/3}O₃-PbTiO₃-PbZrO₃ ternary solid solution system composition as the main component and 0.05 to 3.0 mass% of Ni in terms of NiO, or contains the Pb(Mg, Ni)_{1/3}Nb_{2/3}O₃-PbTiO₃-PbZrO₃ ternary solid solution system composition as the main component. That is, the piezoelectric/electrostrictive body of the present embodiment contains a predetermined ratio of Ni in terms of NiO, or contains, as the main component, the Pb(Mg, Ni)_{1/3}Nb_{2/3}O₃-PbTiO₃-PbZrO₃ ternary solid solution system composition in which a part of Mg is replaced with Ni. Therefore, in the piezoelectric/electrostrictive body of the present embodiment, a pyrochlore phase is inhibited from being formed, and a ratio occupied by a perovskite phase which contributes to an electric field induced strain is large. The article is dense, and has a remarkably high piezoelectric/electrostrictive characteristic.

Moreover, the piezoelectric/electrostrictive body of the present embodiment further contains at least one selected from the group consisting of Mg₂SiO₄, Ni₂SiO₄ and (Mg, Ni)₂SiO₄. Since the piezoelectric/electrostrictive body of the present embodiment contains forsterite and the like in this manner, the article is dense and has a large strain.

In the piezoelectric/electrostrictive body of the present embodiment, a content ratio of the forsterite and the like is 0.2 mol% or less, preferably 0.03 to 0.18 mol%, further preferably 0.05 to 0.15 mol%. When the content ratio of the forsterite and the like exceeds 0.2 mol%, an effect derived by making forsterite incorporated therein is reduced since grains of the forsterite and the like become coarse, and cannot be finely or uniformly dispersed in the sintered article. Additionally, it is not favorable since the strain or the displacement of the resultant piezoelectric/electrostrictive body is reduced due to the increase in a volume ratio of a forsterite phase showing no piezoelectric/electrostrictive property.

Moreover, in a case where the piezoelectric/electrostrictive body of the present embodiment contains the PbMg_{1/3}Nb_{2/3}O₃-PbTiO₃-PbZrO₃ ternary solid solution system composition, the content ratio of Ni is 0.05 to 3.0 mass%, preferably 0.07 to 2.5 mass%, further preferably 0.10 to 2 mass% in terms of NiO. When the content ratio of Ni is within the above numeric value range in terms of NiO, it is possible to manufacture a dense piezoelectric/electrostrictive body having a remarkably high piezoelectric/electrostrictive characteristic. In the article, the pyrochlore phase can be inhibited from being formed, and the ratio occupied by the perovskite phase which contributes to the electric field induced strain is large.

In the piezoelectric/electrostrictive body of the present embodiment, it is preferable that the PbMg_{1/3}Nb_{2/3}O₃-PbZrO₃-PbTiO₃ ternary solid solution system composition is represented by the following formula (1):

Pbₓ(Mg_{y/3}Nb_{2/3})ₐTi_{b}Zr_{c}O₃ (1),

because the article has a higher piezoelectric/electrostrictive characteristic.
In the above formula (1), 0.95 ≤ x ≤ 1.05, 0.8 ≤ y ≤ 1.0, and a, b and c are decimals in a region surrounded with (a, b, c) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including a, b and c as three coordinate axes (with the proviso that a+b+c = 1.000).

Moreover, in the piezoelectric/electrostrictive body of the present embodiment, it is preferable the Pb(Mg, Ni)_{1/3}Nb_{2/3}O₃-PbTiO₃-PbZrO₃ ternary solid solution system composition is represented by the following formula (2):

Pbₓ{(Mg_{1-y}Ni_{y})₍₁₋₃₎×ₐNb_{2/3}}_{b}Ti_{c}Zr_{d}O₃ (2),

because the article has a higher piezoelectric/electrostrictive characteristic.
In the formula (1), 0.95 ≤ x ≤ 1.05, 0.05 ≤ y ≤ 1.00, 0.90 ≤ a ≤ 1.10, and b, c and d are decimals in a region surrounded with (b, c, d) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including b, c and d as coordinate axes (with the proviso that (b+c+d) = 1.000).

Furthermore, it is preferable that the piezoelectric/electrostrictive body of the present embodiment contents the PbMg_{1/3}Nb_{2/3}O₃-PbTiO₃-PbZrO₃ ternary solid solution system composition or the Pb(Mg, Ni)_{1/3}Nb_{2/3}O₃-PbTiO₃-PbZrO₃ ternary solid solution system composition and that the article is constituted of crystal grains having an average grain diameter of 0.5 to 5 µm. It is further preferable that the article is constituted of crystal grains having an average grain diameter of 1 to 4 µm. It is especially preferable that the article is constituted of crystal grains having an average grain diameter of 1.3 to 3.7 µm. If the average grain diameter of the crystal grains is less than 0.5 µm, a domain does not sufficiently develop in the piezoelectric/electrostrictive body in some case. Therefore, there are sometimes generated a drop of flexural displacement and a drop of linearity of the flexural displacement with respect to an electric field in a high electric-field region. On the other hand, if the average grain diameter exceeds 5 µm, the domain sufficiently develops in the piezoelectric/electrostrictive body. However, the large domain does not easily move, and the flexural displacement is reduced in some case.

In the piezoelectric/electrostrictive body of the present embodiment, it is preferable that Pb in the piezoelectric/electrostrictive body is replaced with at least one element selected from the group consisting of Sr, Ba, La and Bi, because it is possible to further improve the piezoelectric/electrostrictive characteristic.

It is to be noted that to replace a part of Pb with Sr and/or Ba, preferably 3 to 10 mol%, further preferably 5 to 8 mol% of Pb is replaced with Sr and/or Ba. To replace a part of Pb with La and/or Bi, preferably 0.2 to 1.0 mol%, further preferably 0.4 to 0.9 mol% of Pb is replaced with La and/or Bi.

Moreover, in the piezoelectric/electrostrictive body of the present embodiment, it is preferable that Ti in the piezoelectric/electrostrictive body is replaced with at least one element selected from the group consisting of Nb, Ta, W and Mo, because it is possible to further improve the piezoelectric/electrostrictive characteristic. It is to be noted that preferably 3 to 10 mol%, further preferably 5 to 8 mol% of Ti is replaced with at least one element selected from the group consisting of Nb, Ta, W and Mo.

It is preferable that the piezoelectric/electrostrictive body of the present embodiment further contains MnO₂ and/or CeO₂, because it is possible to further improve the piezoelectric/electrostrictive characteristic of the article. It is to be noted that a content ratio of MnO₂ and/or CeO₂ is preferably 0.05 to 5 mass%, further preferably 0.1 to 2 mass%.

It is essentially preferable that the piezoelectric/electrostrictive body of the present embodiment contains the PbMg_{1/3}Nb_{2/3}O₃-PbTiO₃-PbZrO₃ ternary solid solution system composition and 0.05 to 3.0 mass% of Ni in terms of NiO, or contains the Pb(Mg, Ni)_{1/3}Nb_{2/3}O₃-PbTiO₃-PbZrO₃ ternary solid solution system composition and the forsterite and the like having a content ratio of 0.2 mol% or less.

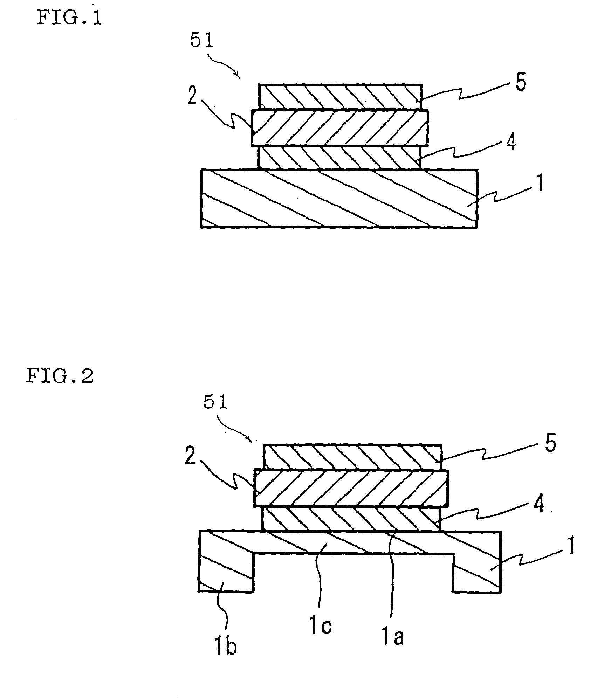

Next, there will be described one embodiment of a first piezoelectric/electrostrictive film type device of the present invention specifically with reference to the drawings. FIG. 1 is a sectional view schematically showing one embodiment of the piezoelectric/electrostrictive film type device of the present invention. As shown in FIG. 1, a first piezoelectric/electrostrictive film type device 51 of the present embodiment includes: a substrate 1 made of a ceramic; a piezoelectric/electrostrictive body 2 formed into a film; and film-like electrodes 4, 5 electrically connected to the piezoelectric/electrostrictive body 2. The piezoelectric/electrostrictive body 2 is solidly attached to the substrate 1 in a state in which the electrode 4 is interposed between the article and the substrate. It is to be noted that the piezoelectric/electrostrictive body may be solidly attached directly to the substrate without interposing the electrode. It is to be noted that in a case where the piezoelectric/electrostrictive body is solidly attached without interposing the electrode, a comb-teeth-like electrode may be formed on the surface of the piezoelectric/electrostrictive body opposite to the surface of the article which comes into contact with the substrate. Here, "solidly attached" mentioned in the present specification indicates a state in which the piezoelectric/electrostrictive body 2 is closely integrated with the substrate 1 or the electrode 4 by a solid phase reaction between the piezoelectric/electrostrictive body and the substrate or the electrode without using any organic or inorganic adhesive.

The piezoelectric/electrostrictive body 2 of the first piezoelectric/electrostrictive film type device 51 of the present embodiment is constituted by forming, into the film, any one of the above-described piezoelectric/electrostrictive bodies of the embodiments of the present invention. Therefore, in the piezoelectric/electrostrictive body 2, a pyrochlore phase is inhibited from being formed, and a ratio occupied by a perovskite phase is large which contributes to an electric field induced strain. The article is dense, and has an excellent crystallinity. Therefore, the first piezoelectric/electrostrictive film type device 51 of the present embodiment, including this piezoelectric/electrostrictive body 2, has a satisfactory piezoelectric/electrostrictive characteristic, and can obtain a large displacement.

Moreover, the piezoelectric/electrostrictive body 2 further contains at least one selected from the group consisting of Mg₂SiO₄, Ni₂SiO₄ and (Mg, Ni)₂SiO₄. That is, since the piezoelectric/electrostrictive body 2 contains the forsterite and the like, the article is dense. The displacement of the first piezoelectric/electrostrictive film type device 51 is large in the present embodiment including this piezoelectric/electrostrictive body 2.

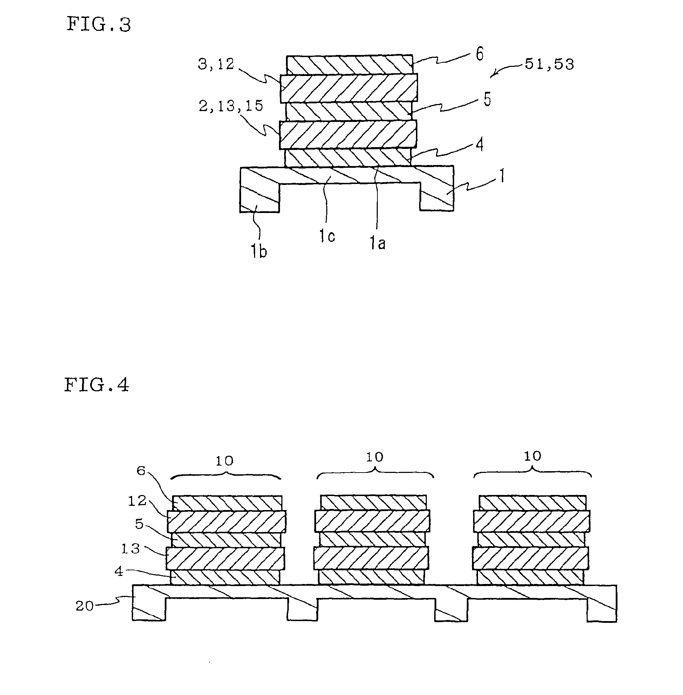

Furthermore, as shown in FIG. 3, it is preferable that the first piezoelectric/electrostrictive film type device 51 of the present embodiment includes: a plurality of piezoelectric/electrostrictive bodies 2, 3; and a plurality of electrodes 4, 5 and 6 and that the plurality of piezoelectric/electrostrictive bodies 2, 3 are alternately sandwiched between or laminated on the plurality of electrodes 4, 5 and 6. This constitution is a so-called multilayered constitution, and is preferable in that a large flexural displacement can be obtained with a low voltage.

In the first piezoelectric/electrostrictive film type device 51 (see FIG. 1) of the present embodiment, a thickness of the piezoelectric/electrostrictive body 2 is preferably 0.5 to 50 µm, further preferably 0.8 to 40 µm, especially preferably 1.0 to 30 µm. If the thickness of the piezoelectric/electrostrictive body 2 is less than 0.5 µm, the article tends to be insufficiently densified. On the other hand, if the thickness of the piezoelectric/electrostrictive body 2 exceeds 50 µm, a contraction stress of the piezoelectric/electrostrictive porcelain composition during firing increases. To prevent the substrate 1 from being destroyed, the thicker substrate 1 is required, and it is difficult to miniaturize the element in some case. It is to be noted that as shown in FIG. 3, in a case where the first piezoelectric/ electrostrictive film type device 51 has a so-called multilayered constitution, the thickness of the piezoelectric/electrostrictive bodies 2, 3 refers to the thickness of each of the piezoelectric/electrostrictive bodies 2, 3.

Next, there will be described one embodiment of a second piezoelectric/electrostrictive film type device of the present invention specifically with reference to the drawings. As shown in FIG. 3, a second piezoelectric/electrostrictive film type device 53 of the present embodiment includes: a substrate 1 made of a ceramic; a plurality of piezoelectric/electrostrictive bodies 2, 3 formed into films; and a plurality of film-like electrodes 4, 5 and 6 electrically connected to these piezoelectric/electrostrictive bodies 2, 3. The piezoelectric/electrostrictive bodies 2, 3 and the electrodes 4, 5 and 6 are alternately laminated on the substrate 1. A lowermost piezoelectric/electrostrictive body 13 positioned in a lowermost layer of the piezoelectric/electrostrictive body 2 or 3 is solidly attached to the substrate 1 in a state in which the electrode 4 positioned in the lowermost layer among the electrodes 4, 5 and 6 is interposed between the article and the substrate. It is to be noted that the lowermost piezoelectric/electrostrictive body may directly be solidly attached onto the substrate without interposing any electrode.

In the second piezoelectric/electrostrictive film type device 53 of the present embodiment, at least one (e.g., a first piezoelectric/electrostrictive body 12) of the plurality of piezoelectric/electrostrictive bodies 2 and 3 is constituted of the following piezoelectric/electrostrictive body (1). Therefore, in the same manner as in the above first piezoelectric/electrostrictive film type device, the first piezoelectric/electrostrictive body 12 is a piezoelectric/electrostrictive film in which a pyrochlore phase is inhibited from being formed, and a ratio occupied by a perovskite phase contributing to an electric field induced strain is large. The film is dense, and has a remarkably high piezoelectric/electrostrictive characteristic.
(1) A piezoelectric/electrostrictive body containing: a PbMg_{1/3}Nb_{2/3}O₃-PbTiO₃-PbZrO₃ ternary solid solution system composition as a main component; 0.05 to 3.0 mass% of Ni in terms of NiO; and at least one selected from the group consisting of Mg₂SiO₄, Ni₂SiO₄ and (Mg, Ni)₂SiO₄, a total content ratio of Mg₂SiO₄, Ni₂SiO₄ and (Mg, Ni)₂SiO₄ being 0.2 mol% or less.
   Here, the content ratio of Ni in the above piezoelectric/electrostrictive body (1) is 0.05 to 3.0 mass%, preferably 0.07 to 2.5 mass%, further preferably 0.10 to 2 mass% in terms of NiO. If the content ratio of Ni is within the above numeric value range in terms of NiO, in the above piezoelectric/electrostrictive body (1), the pyrochlore phase can be inhibited from being formed. It is possible to constitute the piezoelectric/electrostrictive body in which the ratio of occupied by the perovskite phase contributing to the electric field induced strain is large and which is dense and which has a remarkably high piezoelectric/electrostrictive characteristic.
   Moreover, in the second piezoelectric/electrostrictive film type device 53 of the present embodiment, at least one of the plurality of piezoelectric/electrostrictive bodies 2, 3, for example, the piezoelectric/electrostrictive body (e.g., the second piezoelectric/electrostrictive body 13) other than the first piezoelectric/electrostrictive body 12 is constituted of the following piezoelectric/electrostrictive body (2). Therefore, in the same manner as in the above first piezoelectric/electrostrictive body 12, the second piezoelectric/electrostrictive body 13 is a piezoelectric/electrostrictive film in which a pyrochlore phase is inhibited from being formed, and a ratio occupied by a perovskite phase contributing to an electric field induced strain is large. The film is dense, and has a remarkably high piezoelectric/electrostrictive characteristic.
(2) A piezoelectric/electrostrictive body containing: a Pb(Mg, Ni)_{1/3}Nb_{2/3}O₃-PbTiO₃-PbZrO₃ ternary solid solution system composition as a main component; and at least one selected from the group consisting of Mg₂SiO₄, Ni₂SiO₄ and (Mg, Ni)₂SiO₄, a total content ratio of Mg₂SiO₄, Ni₂SiO₄ and (Mg, Ni)₂SiO₄ being 0.2 mol% or less.

Moreover, the piezoelectric/electrostrictive body 2 or 3 further contains at least one selected from the group consisting of Mg₂SiO₄, Ni₂SiO₄ and (Mg, Ni)₂SiO₄. That is, since the piezoelectric/electrostrictive body 2 or 3 contains the forsterite and the like, the article is dense. Furthermore, a displacement of the second piezoelectric/electrostrictive film type device 53 is large in the present embodiment including this piezoelectric/electrostrictive bodies 2 and 3.

In the piezoelectric/electrostrictive bodies 2, 3 constituting the second piezoelectric/electrostrictive film type device 53 of the present embodiment, each content ratio of the forsterite and the like is 0.2 mol% or less, preferably 0.03 to 0.18 mol%, further preferably 0.05 to 0.15 mol%. When the content ratio of the forsterite and the like exceeds 0.2 mol%, an effect derived by making forsterite incorporated therein is reduced since grains of the forsterite and the like become coarse, and cannot be finely or uniformly dispersed in the sintered article. Additionally, it is not favorable since the strain or the displacement of the resultant piezoelectric/electrostrictive body is reduced due to the increase in a volume ratio of a forsterite phase showing no piezoelectric/electrostrictive property.

It is to be noted that in FIG. 3, a lower-layer (substrate 1 side) is shown as the second piezoelectric/electrostrictive body 13, and an upper-layer is shown as the first piezoelectric/electrostrictive body 12, but the second piezoelectric/electrostrictive film type device of the present invention is not limited to such laminating order. That is, the lower-layer closer to the substrate 1 may be the second piezoelectric/electrostrictive body, and the upper-layer may be the first piezoelectric/electrostrictive body, but as shown in FIG. 3, it is preferable that the lower-layer is constituted as the second piezoelectric/electrostrictive body 13, and the upper-layer is constituted as the first piezoelectric/electrostrictive body 12, because the article has a higher piezoelectric characteristic. Furthermore, it is similarly preferable that the article is constituted by forming three or more layers of piezoelectric/electrostrictive bodies having different compositions.

Moreover, each of the plurality of piezoelectric/electrostrictive bodies 2, 3 constituting the second piezoelectric/electrostrictive film type device 53 has a thickness of preferably 0.5 to 50 µm, further preferably 0.8 to 40 µm, especially preferably 1.0 to 30 µm. If the thickness of each of the piezoelectric/electrostrictive bodies 2 and 3 is less than 0.5 µm, the article tends to be insufficiently densified. On the other hand, if the thickness of each of the piezoelectric/electrostrictive bodies 2, 3 exceeds 50 µm, the thicker substrate 1 is required for preventing the substrate 1 from being destroyed, and it becomes difficult to miniaturize the element in some case.

In the second piezoelectric/electrostrictive film type device of the present embodiment, it is preferable that the PbMg_{1/3}Nb_{2/3}O₃-PbZrO₃-PbTiO₃ ternary solid solution system composition is represented by the following formula (1) :

Pbₓ(Mg_{y/3}Nb_{2/3})ₐTi_{b}Zr_{c}O₃ (1),

because the element has a higher piezoelectric/electrostrictive characteristic.
In the formula (1), 0.95 ≤ x ≤ 1.05, 0.8 ≤ y ≤ 1.0, and a, b and c are decimals in a region surrounded with (a, b, c) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including a, b and c as three coordinate axes (with the proviso that a+b+c = 1.000).

Moreover, in the second piezoelectric/electrostrictive film type device of the present embodiment, the Pb(Mg, Ni)_{1/3}Nb_{2/3}O₃-PbTiO₃-PbZrO₃ ternary solid solution system composition is represented by the following formula (2) :

Pbₓ{(Mg_{1-y}Ni_{y})_{(1/3)}×ₐNb_{2/3}}_{b}Ti_{c}Zr_{d}O₃ (2),

in that the element has a higher piezoelectric/electrostrictive characteristic.
In the above formula (2), 0.95 ≤ x ≤ 1.05, 0.05 ≤ y ≤ 1.00, 0.90 ≤ a ≤ 1.10, and b, c and d are decimals in a region surrounded with (b, c, d) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including b, c and d as coordinate axes (with the proviso that (b+c+d) = 1.000).

In the second piezoelectric/electrostrictive film type device 53 (see FIG. 3) of the present embodiment, an Ni content (in terms of NiO) of a lowermost piezoelectric/electrostrictive body 15 (second piezoelectric/electrostrictive body 13) is preferably smaller than that of the piezoelectric/electrostrictive body (e.g., the first piezoelectric/electrostrictive body 12) other than the lowermost piezoelectric/electrostrictive body 15. Accordingly, in the lowermost piezoelectric/electrostrictive body 15, formation of a pyrochlore phase is inhibited, and a ratio occupied by a perovskite phase is large which contributes to a flexural displacement. Therefore, it is possible to improve a piezoelectric characteristic by the composition itself. In addition, the first piezoelectric/electrostrictive body 12 containing more Ni, and a piezoelectric/electrostrictive body (not shown) laminated on an upper layer are little restrained by the substrate 1 with respect to firing contraction, and an effect of containing Ni remarkably appears. Therefore, the first piezoelectric/electrostrictive body 12 and the piezoelectric/electrostrictive body laminated on the upper layer are much densified by a thermal treatment in a manufacturing process. Therefore, under an influence of this densification, the adjacent lowermost piezoelectric/electrostrictive body 15 (second piezoelectric/electrostrictive body 13) is also densified. As a result, it is possible to constitute the piezoelectric/electrostrictive film type device having a higher piezoelectric characteristic in cooperation with the characteristic of the piezoelectric/electrostrictive porcelain composition itself.

In the second piezoelectric/electrostrictive film type device 53 of the present embodiment, from a viewpoint that the element be denser and the formation of the pyrochlore phase be more inhibited, the Ni content (in terms of NiO) of the piezoelectric/electrostrictive porcelain composition constituting the first piezoelectric/electrostrictive body 12 is preferably 0.10 to 2.5 mass%, further preferably 0.15 to 2.0 mass%. A value of a ratio (lowermost/first) between the Ni content (in terms of NiO) of the lowermost piezoelectric/electrostrictive body 15 and that of the first piezoelectric/electrostrictive body 12 is preferably 0.07 to 0.35, further preferably 0.10 to 0.33, especially preferably 0.12 to 0.30. If the value of the (lowermost/first) ratio is less than 0.07, the pyrochlore phase in the first piezoelectric/electrostrictive body 12 easily enlarges. Therefore, the whole piezoelectric characteristic is deteriorated in some case. On the other hand, if the value exceeds 0.35, a degree of the densification of the first piezoelectric/electrostrictive body 12 decreases. Therefore, the lowermost piezoelectric/electrostrictive body 15 is not easily densified, and the whole piezoelectric characteristic is also deteriorated in some case. It is to be noted that even in a case where three or more layers of piezoelectric/electrostrictive bodies are laminated, the (lowermost/first) ratio value is preferably in the above numeric value range. To further promote the densification of each piezoelectric/electrostrictive body, it is preferable that the Ni content (in terms of NiO) of the piezoelectric/electrostrictive body further laminated on the layer above the first piezoelectric/electrostrictive body is equal to or more than that of the lowermost piezoelectric/electrostrictive body.

The substrate constituting the piezoelectric/electrostrictive film type device of the present embodiment is made of the ceramic, but there is not any special restriction on a type of this ceramic. However, in respect of a heat resistance, chemical stability and insulating property, the ceramic is preferable which contains at least one selected from the group consisting of stabilized zirconium oxide, aluminum oxide, magnesium oxide, mullite, aluminum nitride, silicon nitride and glass. Above all, stabilized zirconium oxide is further preferable in that a mechanical strength is large and tenacity is excellent. It is to be noted that "stabilized zirconium oxide" mentioned in the present specification refers to zirconium oxide in which crystal phase transition is inhibited by addition of a stabilizer, and partially stabilized zirconium oxide is included in addition to stabilized zirconium oxide.

Examples of stabilized zirconium oxide include zirconium oxide containing, as the stabilizer, 1 to 30 mol% of calcium oxide, magnesium oxide, yttrium oxide, scandium oxide, ytterbium oxide, cerium oxide or an oxide of a rare earth metal. Above all, it is preferable to contain yttrium oxide as the stabilizer in that a mechanical strength of a vibrating portion is especially high. In this case, preferably 1.5 to 6 mol%, further preferably 2 to 4 mol% of yttrium oxide is contained. It is preferable to further contain 0.1 to 5 mol% of aluminum oxide. It is preferable to further contain 0.1 to 10 mol% of titanium oxide. A crystal phase of stabilized zirconium oxide may be a mixed phase of cubic + monoclinic systems, a mixed phase of tetragonal + monoclinic systems, a mixed phase of cubic + tetragonal + monoclinic systems or the like. From viewpoints of strength, tenacity and durability, it is preferable that a main crystal phase is a tetragonal phase or a mixed phase of tetragonal + cubic systems.

It is to be noted that a thickness of the substrate is preferably 1 µm to 1 mm, further preferably 1.5 to 500 µm, especially preferably 2 to 200 µm. If the thickness of the substrate is less than 1 µm, the mechanical strength of the piezoelectric/electrostrictive element sometimes degrades. On the other hand, in a case where the thickness exceeds 1 mm, when a voltage is applied to the piezoelectric/electrostrictive body, a rigidity of the substrate increases with respect to the generated contraction stress, and the flexural displacement of the piezoelectric/electrostrictive body is sometimes reduced.

However, as shown in FIG. 2, a shape of the substrate 1 may include: a thin portion 1c having a solidly attached surface 1a on one surface thereof and having the above-described thickness; and a thick portion 1b disposed on a portion other than a portion corresponding to this solidly attached surface 1a and having a thickness larger than that of the thin portion 1c. It is to be noted that the electrode 4 (or the piezoelectric/electrostrictive body) is disposed in a region substantially corresponding to the solidly attached surface 1a. When the substrate 1 has such shape, it is possible to constitute the piezoelectric/electrostrictive film type device having a sufficiently large flexural displacement and a large mechanical strength. When a common substrate 20 is constituted as shown in FIG. 4 by continuously forming the shape of the substrate 1 shown in FIG. 2, and used, there can be arranged, on this common substrate 20, a plurality of piezoelectric/electrostrictive element units 10 each including the first piezoelectric/electrostrictive body 12, the second piezoelectric/electrostrictive body 13, and the electrodes 4, 5 and 6.

There is not any special restriction on a surface shape (shape of the surface to which the electrode 4 is solidly attached in FIG. 1) of the substrate in the piezoelectric/electrostrictive film type device of the embodiment of the present invention. Examples of the surface shape include a rectangular shape, a square shape, a triangular shape, an elliptic shape, a circular shape, a curved square shape, a curved rectangular shape, and a composite shape of a combination of these shapes. There is not any special restriction on the whole shape of the substrate, and the substrate may have a capsule shape having an appropriate internal space.

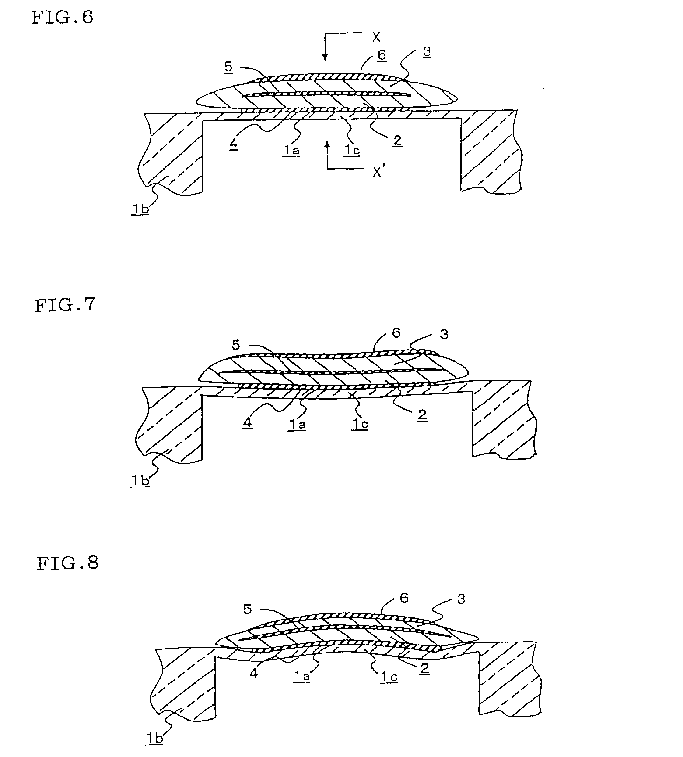

Moreover, as to the shape of the thin portion of the substrate, from a viewpoint that the linearity of the flexural displacement with respect to the electric field is high, the center of the thin portion preferably has a shape bent on a side opposite to a side on which the piezoelectric/electrostrictive bodies 2, 3 are disposed as shown in FIG. 7, or a sectional shape in a thickness direction has a so-called W-shape as shown in FIG. 8. In this shape, opposite end portions of the substrate protrude in a perpendicular direction from a bottom-portion side as viewed from a center line in a longitudinal direction of the substrate, and the center of the shape protrudes upwards. It is to be noted that the bent shape shown in FIG. 8 can be formed utilizing contraction in a step of firing the respective piezoelectric/electrostrictive bodies 2, 3, and the W-shape shown in FIG. 8 can be formed by adjusting firing contraction starting timings or firing contraction amounts of the piezoelectric/electrostrictive bodies 2, 3 and the shape of the thin portion 1c.

In the piezoelectric/electrostrictive film type device of the present embodiment, it is preferable that the electrode is electrically connected to the piezoelectric/electrostrictive body and disposed between the piezoelectric/electrostrictive bodies. It is preferable that the electrode is disposed in a state in which a region of the piezoelectric/electrostrictive body is included, the region substantially contributing to the flexural displacement and the like. As shown in, for example, FIG. 3, it is preferable that the electrodes 4, 5 and 6 are arranged in a region of 80 area% or more including the vicinity of the center of the surface on which the first piezoelectric/electrostrictive body 12 and the second piezoelectric/electrostrictive body 13 are formed.

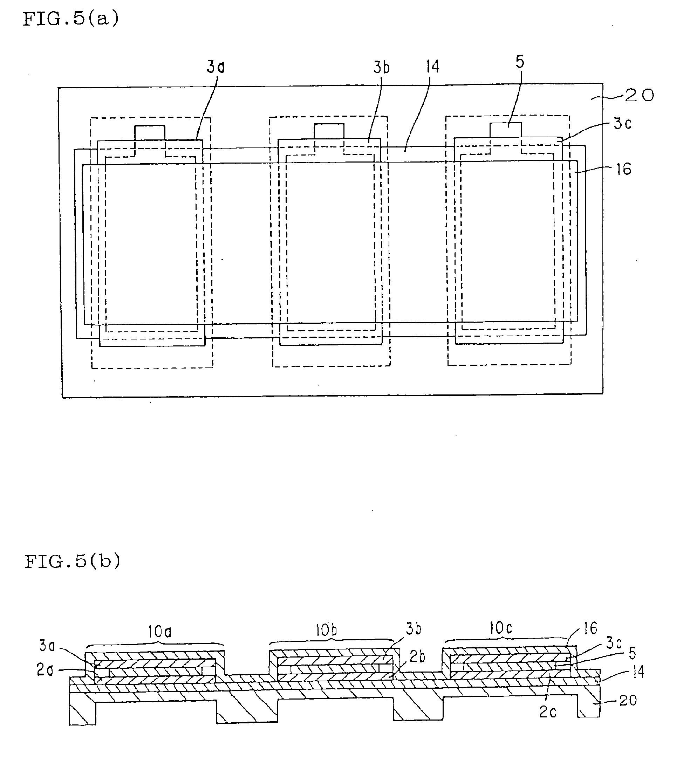

Moreover, as shown in FIGS. 5(a) and 5(b), in a case where the common substrate 20 is shared by a plurality of piezoelectric/electrostrictive element units 10a to 10c, in the respective piezoelectric/electrostrictive element units 10a to 10c, a lowermost-layer electrode 14 and an uppermost-layer electrode 16 are shared by the respective piezoelectric/electrostrictive element units 10a to 10c, and the electrode 14 may be integrated so that the electrode is disposed in regions corresponding to piezoelectric/electrostrictive bodies 2a to 2c and 3a to 3c. Since such integral electrode 14 does not have to have a shape corresponding to individual shapes of the piezoelectric/electrostrictive bodies 2a to 2c and 3a to 3c, and the electrode is easily positioned when formed.

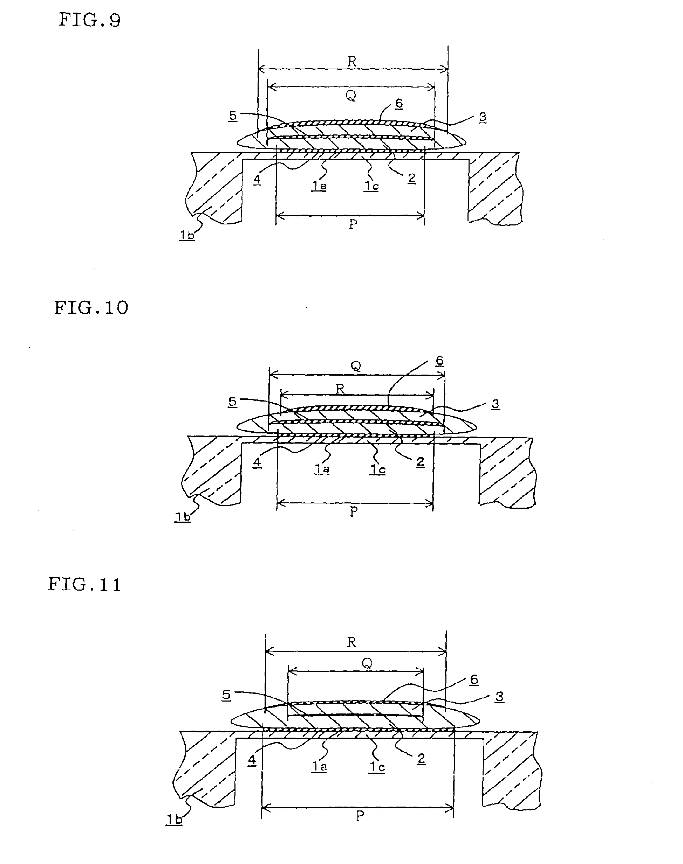

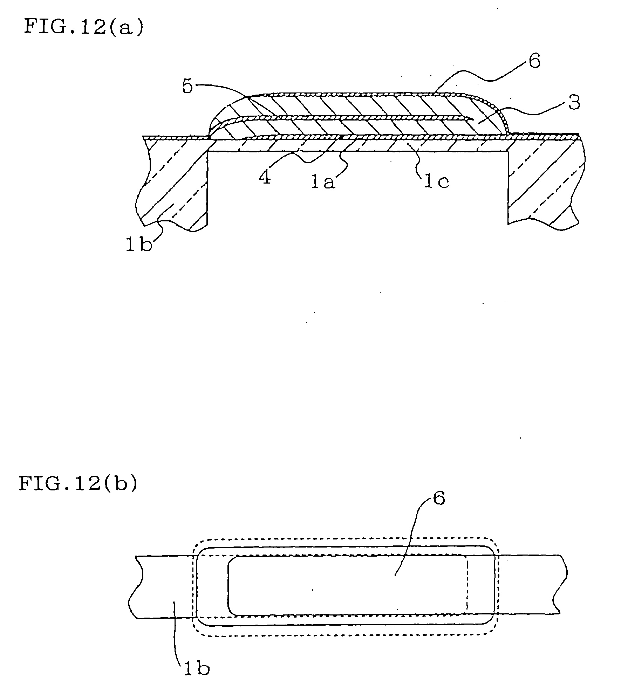

In the piezoelectric/electrostrictive film type device of the present embodiment, examples of a material of the electrode include at least one kind of metal selected from the group consisting of Pt, Pd, Rh, Au, Ag and an alloy of them. Above all, platinum or an alloy containing platinum as a main component is preferable because it has a high heat resistance during firing of the piezoelectric/electrostrictive body. There is not any special restriction on a dimension of the electrode. For example, as shown in FIGS. 6, 12(a) and 12(b), the respective electrodes 4, 5 and 6 may be set to an equal width, and the respective electrodes 4, 5 and 6 may be disposed in positions corresponding to one another in width directions. As shown in FIG. 9, the respective electrodes 4, 5 and 6 are preferably successively arranged from the electrode 4 positioned in the lowermost layer in a broader region including a region corresponding to the electrode positioned in a lower layer. According to such constitution, since the piezoelectric/electrostrictive body positioned in an upper layer can be displaced more largely than the piezoelectric/electrostrictive body positioned in the lower layer, a bending efficiency is enhanced, and the flexural displacement can be more effectively developed.

However, in a case where a driving voltage of the piezoelectric/electrostrictive element is enhanced to obtain a larger flexural displacement, the intermediately positioned electrode 5 is preferably disposed in a region broader than that of each of the electrodes 4 and 6 positioned in the lower and upper layers, respectively as shown in FIG. 10. Alternatively, as shown in FIG. 11, the intermediately positioned electrode 5 is preferably disposed in a region smaller than that of each of the electrodes 4 and 6. According to such constitution, an electric field is hardly applied to the vicinity of each end portion (in a short direction) in which the thicknesses of the piezoelectric/electrostrictive bodies 2, 3 are easily reduced, and dielectric breakdown of the piezoelectric/electrostrictive bodies 2, 3 can be avoided. In a case where a breadth difference is made in a region in which the electrode is disposed, the breadth difference is preferably optimized in consideration of an electric field distribution. For example, as to the electrodes 4 and 5 (or 5 and 6) disposed adjacent to each other in a state in which the piezoelectric/electrostrictive body 2 (or 3) is sandwiched between the electrodes, a value of a ratio of areas (areas of formed surfaces) in which the electrodes are disposed is preferably 0.5 to 2, further preferably 0.67 to 1.5, especially preferably 0.83 to 1.2. It is to be noted that in FIGS. 9 to 11, symbol P denotes a width of a lower electrode, Q denotes a width of an intermediate electrode, and R denotes a width of an upper electrode, respectively.

In the piezoelectric/electrostrictive film type device of the present embodiment, the thickness of the electrode is preferably 15 µm or less, further preferably 5 µm or less. When the thickness exceeds 15 µm, the electrode functions as a relaxing layer, and the flexural displacement is sometimes reduced. It is to be noted that the thickness of the electrode may be 0.05 µm or more from a viewpoint that a substantial function of the electrode be exhibited

Next, there will be described a method of preparing the piezoelectric/electrostrictive porcelain composition of the embodiment of the present invention. To prepare the piezoelectric/electrostrictive porcelain composition, first, a raw material such as an oxide of an element PbO, MgO, Nb₂O₅, TiO₂, ZrO₂, NiO, SiO₂ or the like or carbonate is weighed so as to obtain a desired composition, and they are mixed by a mixing method such as ball milling with some water to obtain a mixed slurry. Subsequently, the resultant mixed slurry can be dried by using a drier or a filter to obtain a mixed material. When the resultant mixed material is calcined and crushed, the piezoelectric/electrostrictive porcelain composition having desired particle diameters can be prepared. In a diffraction strength of the prepared piezoelectric/electrostrictive porcelain composition, measured by an X-ray diffraction device, a ratio between a strength (S₁) of the strongest diffraction line of the pyrochlore phase and a strength (S₂) of the strongest diffraction line of the perovskite phase is preferably (S₁)/(S₂) = 5% or less, further preferably (S₁)/(S₂) = 2% or less. It is to be noted that the calcining may be performed at a temperature of 750 to 1300°C. The crushing may be performed by a method such as the ball milling.

Here, even a slight amount of Si component (mainly SiO₂ or the like) is included in the raw material for use including water in many cases. However, in the piezoelectric/electrostrictive porcelain composition of the present embodiment, a content of the forsterite or the like formed from the Si component is controlled into a range of a very slight amount. Therefore, it is preferable that a high-purity raw material is appropriately selected or the material is purified so as to use an appropriate amount of Si or prevent Si from being excessively mixed. This can control the content of the forsterite or the like in the resultant piezoelectric/electrostrictive porcelain composition. Especially, for example, as to lead oxide (PbO, Pb₃O₄) occupying around 65 mass% of the raw material, it is preferable that there is used lead oxide containing a small amount of SiO₂ as an impurity. To be more specific, it is preferable to use lead oxide containing 10 ppm or less of SiO₂, and it is further preferable to use lead oxide containing 5 ppm or less of SiO₂.

Moreover, as a silica source included in water for use together with the raw material, there is ion-like silica, colloidal silica, particulate silica or the like. Therefore, it is preferable to use water purified using a cation exchange resin, a filter or the like. Specifically, it is preferable to use water having a total silica content of 1 ppm or less, and it is further preferable to use water having a total silica content of 0.5 ppm. When the raw material and water containing a small amount of SiO₂ as the impurity are used together, and Si is further added, it is also preferable that a remarkably slight content of Si is strictly controlled.

The resultant piezoelectric/electrostrictive porcelain composition is crushed using a general crushing device such as a ball mill, an attritor or a bead mill to obtain powder having desired particle diameters. An average particle diameter of the crushed piezoelectric/electrostrictive porcelain composition is preferably 0.1 to 1.0 µm, further preferably 0.2 to 0.7 µm. It is to be noted that the particle diameter may be adjusted by thermally treating the powder of the piezoelectric/electrostrictive porcelain composition at 400 to 750°C. In this case, finer particles are integrated with other to obtain the powder having a uniformed particle diameter, and it is preferably possible to form the piezoelectric/electrostrictive body having the uniformed particle diameter. The piezoelectric/electrostrictive porcelain composition may be prepared by, for example, an alkoxide method, a coprecipitation method or the like. Even during this preparation, it is preferable to use a high-purity raw material or water containing a small amount of Si.

Next, there will be described one example of a method of manufacturing the piezoelectric/electrostrictive body of the embodiment of the present invention. First, the powdered piezoelectric/electrostrictive porcelain composition obtained by the above method is compacted and formed into a desired size under an appropriate pressure. The resultant green compact article is thermally treated (fired) at 1000 to 1400°C for one minute to ten hours, so that a fired article having a predetermined shape can be obtained. Subsequently, after the article is cut into appropriate sizes, a pair of electrodes is formed and a polarization treatment is performed on appropriate conditions.

In the polarization treatment, heating is preferably performed by a known technology. A heating temperature depends on Curie point of a piezoelectric/electrostrictive porcelain, and is preferably set at 40 to 200°C. When the polarization treatment is performed, the piezoelectric/electrostrictive body (bulk article) of the present embodiment can be obtained. It is to be noted that to form the whole shape of the piezoelectric/electrostrictive body into a sheet shape, after adding a plasticizer, a dispersant, a solvent or the like to the piezoelectric/electrostrictive porcelain composition, and forming the composition into a slurry by use of a general mixing device such as a ball mill, the composition can be formed into a sheet shape by use of a general sheet forming machine such as a doctor blade.

Next, there will be described one example of a method of manufacturing a piezoelectric/electrostrictive film type device in the embodiment of the present invention. First, a layer constituted of a piezoelectric/electrostrictive porcelain composition is formed on a substrate made of a ceramic or an electrode formed on the surface of the substrate. Examples of a method of forming the electrode include ion beam, sputtering, vacuum evaporation, PVD, ion plating, CVD, plating, aerosol deposition, screen printing, spraying and dipping. Above all, the sputtering method or the screen printing method is preferable in respect of a bonding property to the substrate and the piezoelectric/electrostrictive body. As to the formed electrode, an appropriate temperature is selected in accordance with the material or forming method of the electrode, and the electrode can be formed integrally with the substrate and/or the piezoelectric/electrostrictive body by the thermal treatment at about 500 to 1400°C. This thermal treatment may be performed every time the electrode is formed, but may be performed together during the firing of the layer constituted of the piezoelectric/electrostrictive porcelain composition. However, after forming the layer constituted of the piezoelectric/electrostrictive porcelain composition, the thermal treatment is not performed at a temperature above a firing temperature of the layer constituted of the piezoelectric/electrostrictive porcelain composition.

Examples of a method of forming the layer constituted of the piezoelectric/electrostrictive porcelain composition on the substrate include ion beam, sputtering, vacuum evaporation, PVD, ion plating, CVD, plating, sol-gel, aerosol deposition, screen printing, spraying and dipping. Above all, the screen printing method is preferable because it is possible to easily and continuously form the layer into a high-precision shape and thickness. It is to be noted that to prepare a multilayered piezoelectric/electrostrictive film type device which is provided with a plurality of piezoelectric/electrostrictive bodies and electrodes and in which they are alternately sandwiched and laminated, the electrode is formed on the layer constituted of the piezoelectric/electrostrictive porcelain composition formed on the substrate by a method similar to the above-described method. It is to be noted that on this electrode, the layers constituted of the piezoelectric/electrostrictive porcelain composition, and the electrodes are alternately and repeatedly formed until desired multiple layers are obtained.

Thereafter, there is integrally fired a laminate obtained by alternately laminating the layers constituted of the piezoelectric/electrostrictive porcelain composition and the electrodes on the substrate. According to the firing, the film-like piezoelectric/electrostrictive body can be solidly attached onto the substrate directly or via the film-like electrode. It is to be noted that the firing does not have to be necessarily integrally performed, and may be successively performed every time one layer constituted of the piezoelectric/electrostrictive porcelain composition is formed, but it is preferable to integrally fire the laminate including the electrodes from a viewpoint of production efficiency.

In this case, a firing temperature is preferably 1000 to 1400°C, further preferably 1100 to 1350°C. When the temperature is below 1000°C, the substrate or the electrode is incompletely solidly attached to the piezoelectric/electrostrictive body, and denseness of the piezoelectric/electrostrictive body becomes insufficient in some case. If the temperature is above 1400°C, an evaporation amount of Pb or Ni in the piezoelectric/electrostrictive porcelain composition increases. Therefore, it sometimes becomes difficult to form the piezoelectric/electrostrictive body having a desired composition. A time to retain the maximum temperature during the thermal treatment is preferably one minute or more and ten hours or less, further preferably five minutes or more and four hours or less. If the maximum temperature retaining time is less than one minute, the piezoelectric/electrostrictive body is easily insufficiently densified, and desired characteristics cannot be obtained in some case. If the maximum temperature retaining time exceeds ten hours, a disadvantage sometimes occurs that a total evaporation amount of Pb or Ni increases even in a case where atmosphere is controlled, the piezoelectric/electrostrictive characteristics are deteriorated, or dielectric breakdown increases.

To form the piezoelectric/electrostrictive body in a state in which the Ni content is controlled into a desired amount, it is preferable that the thermal treatment is performed in a state in which there coexists an atmosphere controlling material having substantially the same Ni content as that of the layer constituted of the piezoelectric/electrostrictive porcelain composition. It is to be noted that the atmosphere controlling material preferably has substantially the same content of another component as that of the formed layer constituted of the piezoelectric/electrostrictive porcelain composition so as to prevent the other component from being evaporated and securely obtain the piezoelectric/electrostrictive body having the desired composition.

Thereafter, the polarization treatment is performed on the appropriate conditions. In the polarization treatment, the heating is preferably performed by the known technology. A heating temperature depends on the Curie point of the piezoelectric/electrostrictive porcelain, and is preferably set at 40 to 200°C.

### [Examples]

The present invention will be specifically described hereinafter based on examples, but the present invention is not limited to these examples. There will be described hereinafter methods of measuring various physical values.

[Si content ratio (in terms of SiO₂)]: The Si content ratio (in terms of SiO₂ (mass%)) in the used raw material (including the piezoelectric/electrostrictive porcelain composition) was measured by an ICP method or a fluorescence X-ray method.

[Content ratio of forsterite or the like]: It was assumed that all of Si changed to forsterite or the like based on an SiO₂ content ratio (mass%) in the used raw material, and the content ratio of the forsterite or the like (a total content ratio (mol%) of Mg₂SiO₄, Ni₂SiO₄ and (Mg, Ni)₂SiO₄) was measured and calculated. It is to be noted that according to a result obtained by EPMA analysis of the piezoelectric/electrostrictive body (bulk article), it has been clarified that Si is mainly detected from the same portion as a portion of Mg and/or Ni. That is, it has been confirmed that a phase other than a phase of the forsterite or the like is hardly constituted, or a ratio of the phase other than the forsterite phase is excessively small, even if the phase is constituted.

[Average grain diameter]: After mirror-polishing the fired article (piezoelectric/electrostrictive body), the article was thermally etched at about 1000°C to clarify grain boundaries. Subsequently, an image was processed, and accordingly an average value of equivalent circle diameters having an equal area was measured as an average grain diameter (µm).

[Strain]: In a strain gauge was attached onto a sample electrode, and a voltage of 3 kV/mm was applied to this sample, a magnitude of strain of the sample (strain amount) was measured.

[Flexural Displacement]: A voltage was applied between electrodes of a piezoelectric/electrostrictive film type device so as to obtain an electric field of 3 kV/mm, and a magnitude of a generated flexural displacement (flexural displacement amount) was measured with a laser displacement measurement unit.

### (Examples 1 to 3, Comparative Example 1)

There was prepared powder of a piezoelectric/electrostrictive porcelain composition containing, as a main component, a ternary solid solution system composition represented by Pb(Mg_{1/3}Nb_{2/3})_{0.12}Ti_{0.45}Zr_{0.43}O₃, and further containing 1.0 mass% (in terms of NiO) of Ni. It is to be noted that during the preparation, SiO₂ was added to a raw material, and the powder of the piezoelectric/electrostrictive porcelain composition was obtained which contained Si at different ratios (0.003, 0.011, 0.019 and 0.041 mass% (in terms of SiO₂)). Each powder was compacted and formed into each size of diameter 20 mm × thickness 6 mm under a pressure of 0.5 t/cm², and fired in a magnesia container at 1200°C for three hours to prepare sintered articles. After working each prepared sintered article into a size of 12 mm × 3 mm × 1 mm, opposite surfaces each having a size of 12 mm × 3 mm were coated with a silver paste to bake an electrode. Subsequently, each article was submerged into a silicon oil at 70°C, a direct-current voltage of 2 kV/mm was applied between the electrodes for 15 minutes to polarize the article, and bulk articles (piezoelectric/ electrostrictive bodies) (Examples 1 to 3, Comparative Example 1) were obtained as samples. Table 1 shows measurement results of various physical values of the resultant bulk articles. It is to be noted that in Table 1, "the strain amount (%)" is described in a relative value (%) in a case where it is assumed that the strain amount of the bulk article of Example 1 is 100.

**[Table 1]**

| | Si content ratio in piezoelectric/ electrostrictive porcelain composition (in terms of SiO₂ (mass%)) | Content ratio of forsterite or the like (mol%) | | Average grain diameter (µm) | Strain amount (%) |
|---|---|---|---|---|---|
| | | Piezo-electric/ electrostrictive porcelain composition | Bulk article | | |
| Example 1 | 0.003 | 0.016 | 0.017 | 1.3 | 100 |
| Example 2 | 0.011 | 0.058 | 0.055 | 2.5 | 103 |
| Example 3 | 0.019 | 0.10 | 0.11 | 4.8 | 96 |
| Comparative Example 1 | 0.041 | 0.22 | 0.23 | 9.4 | 72 |

As shown in Table 1, it is apparent that the bulk articles of Examples 1 to 3 in which the content ratio of the forsterite or the like is 0.2 mol% or less have a large strain amount and excellent piezoelectric/electrostrictive characteristics as compared with the bulk article of Comparative Example 1 in which the content ratio of the forsterite or the like is above 0.2 mol%.

### (Examples 4 to 6, Comparative Example 2)

A lower electrode (dimension: 1.2 × 0.8 mm, thickness: 3 µm) made of platinum was formed by a screen printing process on a ZrO₂ substrate (dimension of a thin portion: 1.6 × 1.1 mm, thickness: 10 µm) stabilized by Y₂O₃ and including the thin portion which was flat, and the electrode was integrated with the substrate by a thermal treatment at 1300°C for two hours. Subsequently, on the substrate, each of piezoelectric/electrostrictive porcelain compositions used in the above "Examples 1 to 3, Comparative Example 1" and having different Si content ratios was laminated into a dimension of 1.3 × 0.9 mm and a thickness of 10 µm by the screen printing process. Subsequently, on each composition, an inner electrode (dimension: 1.0 × 1.1 mm, thickness: 3 µm) made of platinum was laminated by the screen printing process. Further on the electrode, each of the above-described piezoelectric/electrostrictive porcelain compositions was laminated into a dimension of 1.3 × 0.9 mm and a thickness of 10 µm by the screen printing process. Subsequently, an atmosphere controlling material having the same composition as the piezoelectric/electrostrictive porcelain composition was allowed to coexist in a container having a capacity of 0.15 mg/cm³ in terms of NiO per atmosphere unit volume, and the material was thermally treated at 1275°C for two hours. The thickness of each thermally treated piezoelectric/electrostrictive body was 7 µm. Finally, after forming, on the article, an upper electrode (dimension: 1.2 × 0.8 mm, thickness: 0.5 µm) made of gold by the screen printing process, the electrode was thermally treated to manufacture piezoelectric/electrostrictive film type devices (Examples 4 to 6, Comparative Example 2) having double-layer piezoelectric/electrostrictive bodies (piezoelectric/electrostrictive films) formed into films. Table 2 shows measurement results of various physical values of the resultant piezoelectric/electrostrictive film type devices. It is to be noted that in Table 2, "the flexural displacement amount (%)" is described in a relative value (%) in a case where it is assumed that the flexural displacement amount of the piezoelectric/electrostrictive film type device of Example 4 is 100.

**[Table 2]**

| | Si content ratio in piezoelectric/ electrostrictive porcelain composition (in terms of SiO₂ (mass%)) | Content ratio of forsterite or the like(mol%) | | Average grain diameter (µm) | Flexural displacement amount (%) |
|---|---|---|---|---|---|
| | | Piezoelectric/ electrostrictive porcelain composition | piezoelectric/ electrostrictive film | | |
| Example 4 | 0.003 | 0.016 | 0.016 | 0.8 | 100 |
| Example 5 | 0.011 | 0.058 | 0.054 | 2.2 | 101 |
| Example 6 | 0.019 | 0.10 | 0.10 | 4.2 | 94 |
| Comparative Example 2 | 0.041 | 0.22 | 0.24 | 8.4 | 67 |

As shown in Table 2, it is apparent that the piezoelectric/electrostrictive film type devices of Examples 4 to 6 including the piezoelectric/electrostrictive films in which the content ratio of the forsterite or the like is 0.2 mol% or less have a large flexural displacement amount and excellent piezoelectric/electrostrictive characteristics as compared with the piezoelectric/electrostrictive film type device of Comparative Example 2 including the piezoelectric/electrostrictive film in which the content ratio of the forsterite or the like is above 0.2 mol%.

### (Examples 7 to 9, Comparative Example 3)

There was prepared powder of a piezoelectric/electrostrictive porcelain composition containing, as a main component, a ternary solid solution system composition represented by Pb{(Mg_{0.87}Ni_{0.13})_{1/3}Nb_{2/3}}_{0.12}Ti_{0.45}Zr_{0.43}O₃. It is to be noted that during the preparation, SiO₂ was added to a raw material, and the powder of the piezoelectric/ electrostrictive porcelain composition was obtained which contained Si at different ratios (0.003, 0.013, 0.022 and 0.043 mass% (in terms of SiO₂)). Each powder was compacted and formed into each size of diameter 20 mm × thickness 6 mm under a pressure of 0.5 t/cm², and fired in a magnesia container at 1200°C for three hours to thereby prepare sintered articles. After working each prepared sintered article into a size of 12 mm × 3 mm × 1 mm, opposite surfaces each having a size of 12 mm × 3 mm were coated with a silver paste to bake an electrode. Subsequently, each article was submerged into a silicon oil at 70°C, a direct-current voltage of 2 kV/mm was applied between the electrodes for 15 minutes to polarize the article, and bulk articles (piezoelectric/electrostrictive bodies) (Examples 7 to 9, Comparative Example 3) were obtained as samples. Table 3 shows measurement results of various physical values of the resultant bulk articles. It is to be noted that in Table 3, "the strain amount (%)" is described in a relative value (%) in a case where it is assumed that the strain amount of the bulk article of Example 1 is 100.

**[Table 3]**

| | Si content ratio in piezoelectric/ electrostrictive porcelain composition electro(in terms of SiO₂ (mass%)) | Content ratio of forsterite or the like(mol%) | | Average diameter (µm) | Strain grain amount (%) |
|---|---|---|---|---|---|
| | | Piezoelectric/ strictive porcelain composition | Bulk article | | |
| Example 7 | 0.005 | 0.027 | 0.026 | 1.5 | 107 |
| Example 8 | 0.013 | 0.070 | 0.074 | 2.7 | 106 |
| Example 9 | 0.022 | 0.12 | 0.11 | 4.6 | 104 |
| Comparative Example 3 | 0.043 | 0.23 | 0.22 | 8.9 | 80 |

As shown in Table 3, it is apparent that the bulk articles of Examples 7 to 9 in which the content ratio of the forsterite or the like is 0.2 mol% or less have a large strain amount and excellent piezoelectric/electrostrictive characteristics as compared with the bulk article of Comparative Example 3 in which the content ratio of the forsterite or the like is above 0.2 mol%.

### (Examples 10 to 12, Comparative Example 4)

A lower electrode (dimension: 1.2 × 0.8 mm, thickness: 3 µm) made of platinum was formed by a screen printing process on a ZrO₂ substrate (dimension of a thin portion: 1.6 × 1.1 mm, thickness: 10 µm) stabilized by Y₂O₃ and including the thin portion which was flat, and the electrode was integrated with the substrate by a thermal treatment at 1300°C for two hours. Subsequently, on the substrate, each of piezoelectric/electrostrictive porcelain compositions used in the above "Examples 7 to 9, Comparative Example 3" and having different Si content ratios was laminated into a dimension of 1.3 × 0.9 mm and a thickness of 10 µm by the screen printing process. Subsequently, on each composition, an inner electrode (dimension: 1.0 × 1.1 mm, thickness: 3 µm) made of platinum was laminated by the screen printing process. Further on the electrode, each of the above-described piezoelectric/electrostrictive porcelain compositions was laminated into a dimension of 1.3 × 0.9 mm and a thickness of 10 µm by the screen printing process. Subsequently, an atmosphere controlling material having the same composition as the piezoelectric/electrostrictive porcelain composition was allowed to coexist in a container having a capacity of 0.15 mg/cm³ in terms of NiO per atmosphere unit volume, and the material was thermally treated at 1275°C for two hours. The thickness of each thermally treated piezoelectric/electrostrictive body was 7 µm. Finally, after forming, on the article, an upper electrode (dimension: 1.2 × 0.8 mm, thickness: 0.5 µm) made of gold by the screen printing process, the electrode was thermally treated to manufacture piezoelectric/electrostrictive film type devices (Examples 10 to 12, Comparative Example 4) having double-layer piezoelectric/electrostrictive bodies (piezoelectric/electrostrictive films) formed into films. Table 4 shows measurement results of various physical values of the resultant piezoelectric/electrostrictive film type devices. It is to be noted that in Table 4, "the flexural displacement amount (%)" is described in a relative value (%) in a case where it is assumed that the flexural displacement amount of the piezoelectric/electrostrictive film type device of Example 4 is 100.

**[Table 4]**

| | Si content ratio in piezoelectric/ electrostrictive porcelain composition (in terms of SiO₂ (mass%)) | Content ratio of forsterite or the like(mol%) | | Average rain diameter (µm) | Flexural displace -ment amount (%) |
|---|---|---|---|---|---|
| | | Piezoelectric/ electrostrictive porcelain composition | Piezo-electric/ electrostrictive film | | |
| Example 10 | 0.005 | 0.027 | 0.030 | 0.7 | 105 |
| Example 11 | 0.013 | 0.070 | 0.072 | 1.9 | 103 |
| Example 12 | 0.022 | 0.12 | 0.11 | 3.9 | 100 |
| Comparative Example 4 | 0.043 | 0.23 | 0.21 | 7.3 | 77 |

As shown in Table 4, it is apparent that the piezoelectric/electrostrictive film type devices of Examples 4 to 6 including the piezoelectric/electrostrictive films in which the content ratio of the forsterite or the like is 0.2 mol% or less have a large flexural displacement amount and excellent piezoelectric/electrostrictive characteristics as compared with the piezoelectric/electrostrictive film type device of Comparative Example 2 including the piezoelectric/electrostrictive film in which the content ratio of the forsterite or the like is above 0.2 mol%.

### (Example 13)

A lower electrode (dimension: 1.2 × 0.8 mm, thickness: 3 µm) made of platinum was formed by a screen printing process on a ZrO₂ substrate (dimension of a thin portion: 1.6 × 1.1 mm, thickness: 10 µm) stabilized by Y₂O₃ and including the thin portion which was flat, and the electrode was integrated with the substrate by a thermal treatment at 1300°C for two hours. Subsequently, there was laminated, on the substrate, a piezoelectric/electrostrictive porcelain composition containing as a main component a ternary solid solution system composition represented by Pb{(Mg_{0.87}Ni_{0.13})_{1/3}Nb_{2/3}}_{0.12}Ti_{0.45}Zr_{0.43}O₃ and further containing 0.007 mass% of Si (in terms of SiO₂) in a dimension of 1.3 × 0.9 mm and a thickness of 10 µm by the screen printing process. Subsequently, on the composition, an inner electrode (dimension: 1.0 × 1.1 mm, thickness: 3 µm) made of platinum was laminated by the screen printing process.

Further on the electrode, the piezoelectric/electrostrictive porcelain compositions was laminated into a dimension of 1.3 × 0.9 mm and a thickness of 10 µm by the screen printing process. The composition contained: as a main component a ternary solid solution system composition represented by Pb(Mg_{1/3}Nb_{2/3})_{0.12}Ti_{0.45}Zr_{0.43}O₃; 1.0 mass% (in terms of NiO) of Ni; and 0.009 mass% (in terms of SiO₂) of Si. Subsequently, an atmosphere controlling material having the same composition as the piezoelectric/electrostrictive porcelain composition laminated on an upper layer was allowed to coexist in a container having a capacity of 0.15 mg/cm³ in terms of NiO per atmosphere unit volume, and the material was thermally treated at 1275°C for two hours. The thickness of the thermally treated piezoelectric/electrostrictive body was 7 µm. Finally, after forming, on the article, an upper electrode (dimension: 1.2 × 0.8 mm, thickness: 0.5 µm) made of gold by the screen printing process, the electrode was thermally treated to manufacture a piezoelectric/electrostrictive film type device (Example 13) having a double-layer piezoelectric/electrostrictive body (piezoelectric/electrostrictive film) formed into a film.

### (Comparative Example 5)

There was manufactured a piezoelectric/electrostrictive film type device (Comparative Example 5) having a double-layer piezoelectric/electrostrictive body (piezoelectric/electrostrictive film) formed into a film in the same manner as in Example 13 described above, except that: (1) there was laminated a piezoelectric/electrostrictive film type device containing as a main component a ternary solid solution system composition represented by Pb{(Mg_{0.87}Ni_{0.13})_{1/3}Nb_{2/3}}_{0.12}Ti_{0.45}Zr_{0.43}O₃ and further containing 0.043 mass% (in terms of SiO₂) of Si; and (2) there was laminated on an upper layer a piezoelectric/electrostrictive porcelain composition containing as a main component a ternary solid solution system composition represented by Pb(Mg_{1/3}Nb_{2/3})_{0.12}Ti_{0.45}Zr_{0.43}O₃, 1.0 mass% (in terms of NiO) of Ni and 0.0009 mass% (in terms of SiO₂) of Si.

Table 5 shows measurement results of various physical values of the piezoelectric/electrostrictive film type devices of Example 15 and Comparative Example 5. It is to be noted that in Table 5, "the flexural displacement amount (%)" is described in a relative value (%) in a case where it is assumed that the flexural displacement amount of the piezoelectric/electrostrictive film type device of Example 4 is 100.

**[Table 5]**

| | Si content ratio in piezoelectric/ electrostrictive element (in terms of SiO₂ (mass%)) | | Content ratio of forsterite or the like (mol%) | | | | Average grain diameter (µm) | Flexural displacement amount (%) |
|---|---|---|---|---|---|---|---|---|
| | | | Piezoelectric/ electrostrictive porcelain composition | | Piezoelectric/ electrostrictive film | | | |
| | Lower layer | Upper layer | Lower layer | Upper layer | Lower layer | Upper layer | | |
| Example 13 | 0.007 | 0.009 | 0.038 | 0.047 | 0.042 | 0.045 | 0.8 | 103 |
| Comparative Example 5 | 0.043 | 0.041 | 0.23 | 0.22 | 0.21 | 0.22 | 8.2 | 70 |

As shown in Table 5, it is apparent that the piezoelectric/electrostrictive film type devices of Example 13 having the piezoelectric/electrostrictive film in which the content ratio of the forsterite or the like is 0.2 mol% or less has a large flexural displacement amount and excellent piezoelectric/electrostrictive characteristics as compared with the piezoelectric/electrostrictive film type device of Comparative Example 5 having the piezoelectric/electrostrictive film in which the content ratio of the forsterite or the like is above 0.2 mol%.

A piezoelectric/electrostrictive body and a piezoelectric/electrostrictive element of the present invention have excellent piezoelectric/electrostrictive characteristics, and are suitable for an actuator, a sensor or the like.

## Claims

1. A piezoelectric/electrostrictive porcelain composition containing: a PbMg_{1/3}Nb_{2/3}O₃-PbTiO₃-PbZrO₃ ternary solid solution system composition as a main component; and
0.05 to 3.0 mass% of Ni in terms of NiO, or containing: a Pb(Mg, Ni)_{1/3}Nb_{2/3}O₃-PbTiO₃-PbZrO₃ ternary solid solution system composition as a main component; and
at least one selected from the group consisting of Mg₂SiO₄, Ni₂SiO₄ and (Mg, Ni)₂SiO₄,
a total content ratio of Mg₂SiO₄, Ni₂SiO₄ and (Mg, Ni)₂SiO₄ being 0.2 mol% or less.

2. The piezoelectric/electrostrictive porcelain composition according to claim 1, wherein the PbMg_{1/3}Nb_{2/3}O₃-PbTiO₃-PbZrO₃ ternary solid solution system composition is represented by the following formula (1):
Pbₓ(Mg_{y/3}Nb_{2/3})ₐTi_{b}Zr_{c}O₃ (1),
wherein 0.95 ≤ x ≤ 1.05, 0.8 ≤ y ≤ 1.0, and a, b and c are decimals in a region surrounded with (a, b, c) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including a, b and c as three coordinate axes (with the proviso that a+b+c = 1.000).

3. The piezoelectric/electrostrictive porcelain composition according to claim 1 or 2, wherein the Pb(Mg, Ni)_{1/3}Nb_{2/3}O₃-PbTiO₃-PbZrO₃ ternary solid solution system composition is represented by the following formula (2):
Pbₓ{(Mg_{1-y}Ni_{y})_{(1/3)}×ₐNb_{2/3}}_{b}Ti_{c}Zr_{d}O₃ (2),
wherein 0.95 ≤ x ≤ 1.05, 0.05 ≤ y ≤ 1.00, 0.90 ≤ a ≤ 1.10, and b, c and d are decimals in a region surrounded with (b, c, d) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including b, c and d as coordinate axes (with the proviso that (b+c+d) = 1.000).

4. A piezoelectric/electrostrictive body containing: a PbMg_{1/3}Nb_{2/3}O₃-PbTiO₃-PbZrO₃ ternary solid solution system composition as a main component; and
0.05 to 3.0 mass% of Ni in terms of NiO, or containing: a Pb(Mg, Ni)_{1/3}Nb_{2/3}O₃-PbTiO₃-PbZrO₃ ternary solid solution system composition as a main component; and
at least one selected from the group consisting of Mg₂SiO₄, Ni₂SiO₄ and (Mg, Ni)₂SiO₄,
a total content ratio of Mg₂SiO₄, Ni₂SiO₄ and (Mg, Ni)₂SiO₄ being 0.2 mol% or less.

5. The piezoelectric/electrostrictive body according to claim 4, wherein the PbMg_{1/3}Nb_{2/3}O₃-PbTiO₃-PbZrO₃ ternary solid solution system composition is represented by the following formula (1):
Pbₓ(Mg_{y/3}Nb_{2/3})ₐTi_{b}Zr_{c}O₃ (1),
wherein 0.95 ≤ x ≤ 1.05, 0.8 ≤ y ≤ 1.0, and a, b and c are decimals in a region surrounded with (a, b, c) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including a, b and c as three coordinate axes (with the proviso that a+b+c = 1.000).

6. The piezoelectric/electrostrictive body according to claim 4 or 5, wherein the Pb (Mg, Ni)_{1/3}Nb_{2/3}O₃-PbTiO₃-PbZrO₃ ternary solid solution system composition is represented by the following formula (2):
Pbₓ{(Mg_{1-y}Ni_{y}) _{(1/3)}×ₐNb_{2/3}}_{b}Ti_{c}Zr_{d}O₃ (2),
wherein 0.95 ≤ x ≤ 1.05, 0.05 ≤ y ≤ 1.00, 0.90 ≤ a ≤ 1.10, and b, c and d are decimals in a region surrounded with (b, c, d) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including b, c and d as coordinate axes (with the proviso that (b+c+d) = 1.000).

7. A piezoelectric/electrostrictive film type device comprising:
a substrate made of a ceramic;
the piezoelectric/electrostrictive body formed into a film according to any one of claims 4 to 6; and
a film-like electrode electrically connected to the piezoelectric/electrostrictive body,
the piezoelectric/electrostrictive body being solidly attached to the substrate directly or via the electrode.

8. The piezoelectric/electrostrictive film type device according to claim 7, further comprising:
a plurality of piezoelectric/electrostrictive bodies; and
a plurality of electrodes,
the plurality of piezoelectric/electrostrictive bodies being alternately sandwiched between and laminated on the plurality of electrodes.

9. A piezoelectric/electrostrictive film type device comprising:
a substrate made of a ceramic;
a plurality of piezoelectric/electrostrictive bodies formed into films; and
a plurality of film-like electrodes electrically connected to the piezoelectric/electrostrictive bodies,
the piezoelectric/electrostrictive bodies and the electrodes being alternately laminated on the substrate,
a lowermost piezoelectric/electrostrictive body positioned in a lowermost layer of the piezoelectric/electrostrictive bodies being solidly attached to the substrate directly or via a lowermost electrode positioned in a lowermost layer of the electrodes,
wherein at least one of the piezoelectric/electrostrictive bodies is constituted of the following piezoelectric/electrostrictive body (1), and
at least one of the other piezoelectric/electrostrictive bodies is constituted of the following piezoelectric/electrostrictive body (2):
(1) a piezoelectric/electrostrictive body containing: a PbMg_{1/3}Nb_{2/3}O₃-PbTiO₃-PbZrO₃ ternary solid solution system composition as a main component; 0.05 to 3.0 mass% of Ni in terms of NiO; and at least one selected from the group consisting of Mg₂SiO₄, Ni₂SiO₄ and (Mg, Ni)₂SiO₄,
a total content ratio of Mg₂SiO₄, Ni₂SiO₄ and (Mg, Ni)₂SiO₄ being 0.2 mol% or less; and
(2) a piezoelectric/electrostrictive body containing: a Pb(Mg, Ni)_{1/3}Nb_{2/3}O₃-PbTiO₃-PbZrO₃ ternary solid solution system composition as a main component; and at least one selected from the group consisting of Mg₂SiO₄, Ni₂SiO₄, and (Mg, Ni)₂SiO₄,
a total content ratio of Mg₂SiO₄, Ni₂SiO₄, and (Mg, Ni)₂SiO₄ being 0.2 mol% or less.

10. The piezoelectric/electrostrictive film type device according to claim 9, wherein the PbMg_{1/3}Nb_{2/3}O₃-PbTiO₃-PbZrO₃ ternary solid solution system composition is represented by the following formula (1):
Pbₓ(Mg_{y/3}Nb_{2/3})ₐTi_{b}Zr_{c}O₃ (1),
wherein 0.95 ≤ x ≤ 1.05, 0.8 ≤ y ≤ 1.0, and a, b and c are decimals in a region surrounded with (a, b, c) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including a, b and c as three coordinate axes (with the proviso that a+b+c = 1.000).

11. The piezoelectric/electrostrictive film type device according to claim 9 or 10, wherein the Pb(Mg, Ni)_{1/3}Nb_{2/3}O₃-PbTiO₃-PbZrO₃ ternary solid solution system composition is represented by the following formula (2):
Pbₓ{ (Mg_{1-y}Ni_{y}) _{(1/3)}×ₐNb_{2/3}}_{b}Ti_{c}Zr_{d}O₃ (2),
wherein 0.95 ≤ x ≤ 1.05, 0.05 ≤ y ≤ 1.00, 0.90 ≤ a ≤ 1.10, and b, c and d are decimals in a region surrounded with (b, c, d) = (0.550, 0.425, 0.025), (0.550, 0.325, 0.125), (0.375, 0.325, 0.300), (0.050, 0.425, 0.525), (0.050, 0.525, 0.425) and (0.375, 0.425, 0.200) in a coordinate including b, c and d as coordinate axes (with the proviso that (b+c+d) = 1.000).

12. The piezoelectric/electrostrictive film type device according to any one of claims 9 to 11, wherein a content of Ni of the lowermost piezoelectric/electrostrictive body in terms of NiO is smaller than that of Ni of the piezoelectric/electrostrictive body other than the lowermost piezoelectric/electrostrictive body in terms of NiO.
